# EUROPEAN PATENT APPLICATION

(11) **EP 1 702 965 A2**
(43) Date of publication of application: **20.09.2006**
(21) Application number: 06005539.9
(22) Date of filing: 17.03.2006
(51) Int. Cl.: C09G 1/02, H01L 21/321

(54) **Metal chemical mechanical polishing solution and polishing method**

(30) Priority: 17.03.2005 JP 2005077102
(71) Applicant: FUJI PHOTO FILM CO., LTD., Minami-Ashigara-shi, Kanagawa (JP)
(72) Inventor: Yamashita, Katsuhiro,c/oFuji Photo Film Co., Ltd, Shizuoka (JP)
(74) Representative: HOFFMANN EITLE

(57) **Abstract**

A metal polishing solution comprising an oxidizing agent, wherein assuming that an oxidation reaction rate immediately after an oxidation of a metal to be polished starts at its surface is E1 and an oxidation reaction rate when an oxidation reaction reaches a stationary state is E2, E1/E2 is 1.5 or more and a time required for reaching an oxidation reaction rate of (E1+E2)/2 is from 1 to 50 seconds.

## Description

### FIELD OF THE INVENTION

The present invention relates to the production of a semiconductor device, more specifically, the present invention relates to a metal polishing solution for use in the wiring step of a semiconductor device, and also relates to a polishing method using the same.

### BACKGROUND OF THE INVENTION

In the development of a semiconductor device as represented by a semiconductor integrated circuit (hereinafter referred to as "LSI"), high-density and high-integration fabrication by the fine multilayer wiring is recently demanded for obtaining a highly integrated high-speed semiconductor device. For realizing this, a technique of chemical-mechanical polishing (hereinafter referred to as "CMP") is being used. This is a method used for polishing an insulating thin film (e.g., SiO₂) or a metal thin film used for wiring, thereby smoothening the substrate or removing an excess metal thin film produced at the wiring formation, and is disclosed, for example, in U.S. Patent 4,944,836.

The metal polishing solution used for CMP generally contains an abrasive grain (e.g., alumina) and an oxidizing agent (e.g., hydrogen peroxide). As for the fundamental mechanism thereof, it is considered that the metal surface is oxidized by the oxidizing agent and the oxide film is removed by the abrasive grain.

However, when CMP is performed by using a metal polishing solution containing such a solid abrasive grain, there may arise, for example, a polishing scratch (scratching), a phenomenon that the entire surface to be polished is excessively polished (thinning), a phenomenon that the polished metal surface is recessed like a dish (dishing), or a phenomenon that the insulating material between metal wirings is excessively polished and moreover, the wiring metal surface is recessed like a dish (erosion).

Also, this technique has a problem in view of the cost, for example, the washing step which is usually performed after the polishing for removing the polishing solution remaining on the semiconductor surface becomes complicated due to use of a polishing solution containing a solid abrasive grain and furthermore, the solid abrasive grain needs to be precipitated and separated at the treatment of solution (waste solution) after the washing.

In order to solve these problems, for example, a metal surface polishing method using a combination of an abrasive grain-free polishing solution and dry etching is known. JP-A-2001-127019 (the term "JP-A" as used herein means an "unexamined published Japanese patent application") discloses a metal polishing solution comprising hydrogen peroxide/malic aaid/benzotriazole/amanonium polyacrylate and water. According to these methods, the metal film in the convex part of a semiconductor substrate is selectively CMPed and the metal film is allowed to remain in the concave part, thereby obtaining a desired semiconductor pattern. Since CMP proceeds by the friction with a polishing pad which is mechanically by far softer than the conventional means containing a solid abrasive grain, generation of scratching is reduced.

As for the metal for wiring, tungsten and aluminum have been heretofore generally used in the interconnect structure. However, for the purpose of more enhancing the performance, LSI using copper having a wiring resistance lower than that of those metals has been developed. As for this copper wiring method, a damascene process described, for example, in JP-A-2-278822 is known. Also, a dual damascene process of simultaneously forming a contact hole and a wiring groove in an interlayer insulating film and embedding a metal in both the hole and the groove is being widely used. As the target material for this copper wiring, a copper target with high impurity of five-nine or more has been shipped. However, along with recent fine wiring for achieving still higher density, enhancement of electrical conductivity or electronic properties of the copper wiring is required. To satisfy this requirement, use of a copper alloy obtained by adding a third component to high-purity copper is being studied. At the same time, a high-speed metal polishing technique capable of exerting high productivity without contaminating such a high-precision and high-purity material is demanded.

Also, in recent years, the wafer size at the production of LSI becomes large for enhancing the productivity and a wafer with a diameter of 200 mm or more is generally used at present. Production of even a wafer with a size of 300 mm or more is starting. This enlargement of the size brings about a large difference in the polishing rate between the center part and the peripheral part of a wafer and accordingly, demands for improvement in the in-plane uniformity are increasing.

Furthermore, a silica (SiO₂) film formed by a vacuum process such as CVD method has been heretofore often used as an interlayer insulating film in a semiconductor device or the like. In recent years, a coating-type insulating film mainly comprising a hydrolysis product of tetraalkoxysilane, called SOG (spin-on-glass) film, is also being used. In addition, along with increase in the integration of a semiconductor device or the like, an interlayer insulating film mainly comprising polyorganosiloxane and having a low dielectric constant, called organic SOG, has been developed.

Particularly, chemical-mechanical polishing (CMP) is performed in the semiconductor production process for achieving higher integration or multilayer fabrication of a semiconductor device or the like, but there is a problem that due to load produced in the polishing step, a defect is generated in the interlayer insulating film with a low dielectric constant. Accordingly, not only an interlayer insulating film material with a lower dielectric constant and excellent mechanical strength is demanded but also low-load polishing not adversely affecting such a material is needed.

With respect to the chemical polishing method having no mechanical means for copper and copper alloy, that is, reduced in the load, the method described in JP-A-49-122432 is known. However, the chemical polishing method only by the dissolution activity has a problem in view of flatness due to generation of dishing or the like, as compared with CMP of selectively effecting chemical-mechanical polishing of a metal film in the convex part.

The CMP process in the copper wiring formation step is required to satisfy a high polishing rate in view of productivity and good dishing performance in view of reliability of the device. High oxidation reactivity or strong mechanical polishing is preferred for achieving a high polishing rate, but high oxidation reactivity or strong mechanical polishing brings about dishing which is overpolishing in the wiring part. The dishing is excessive excavation of the wiring part and this means that the concave part is polished. Accordingly, a slurry ensuring good dishing can be said to be a slurry having a low polishing rate for the concave part with respect to the polishing rate for the convex part. A slurry giving a high polishing rate for the convex part generally has a high polishing rate also for the concave part and it is very difficult to establish both a high polishing rate and a good dishing performance. To solve this problem, for example, JP-A-2001-152135 discloses a method of compounding an organic particle and an inorganic particle to increase the pressure dependency of the polishing force, but the effect is not sufficient.

### SUMMARY OF THE INVENTION

An object of the present invention is to clarify the physical properties required of a metal polishing solution for satisfying both a high polishing rate and a good dishing performance and provide a metal polishing solution succeeded in achieving these physical properties.

As a result of intensive investigations on the above-described problems of a metal polishing solution, the present inventors have found that these problems can be solved by using the following metal polishing solution. The object can be achieved by this finding.

That is, the present invention is as follows.
(1) A metal polishing solution comprising an oxidizing agent, wherein assuming that the oxidation reaction rate immediately after the oxidation of a metal to be polished starts at its surface is E1 and the oxidation reaction rate when the oxidation reaction reaches the stationary state is E2, E1/E2 is 1.5 or more and the time required for reaching an oxidation reaction rate of (E1+E2)/2 is from 1 to 50 seconds.
(2) The metal polishing solution as described in (1) above, wherein the oxidation reaction rate E2 when the oxidation reaction reaches the stationary state is 1.0 nm/min or less.
(3) The metal polishing solution as described in (1) or (2) above, which comprises a heteroaromatic ring compound having higher adsorptivity to copper oxide than the adsorptivity to metallic copper.
(4) The metal polishing solution as described in (3) above, wherein the heteroaromatic ring compound is at least one member selected from the compounds represented by the following formulae (I) and (II): 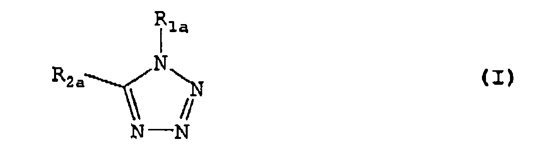 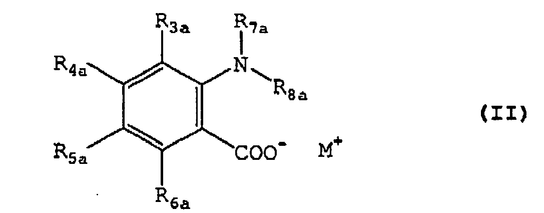 wherein in formula (I), R₁ₐ and R₂ₐ, each independently represents a hydrogen atom or a substituent, and R₁ₐ and R₂ₐ, may combine with each other to form a ring, provided that when R₁ₐ and R₂ₐ both are a hydrogen atom, the compound represented by formula (I) may be a tautomer thereof, and
   in formula (II), R₃ₐ to R₈ₐ each independently represents a hydrogen atom or a substituent, adjacent two members out of R₃ₐ to R₆ₐ may combine with each other to form a ring, and M⁺ represents a cation.
(5) The metal polishing solution as described in (1) to (4) above, which comprises an abrasive grain in a proportion of 2 mass% or less.
(6) The metal polishing solution as described in (5) above, wherein the average diameter of the abrasive grain is 50 nm or less and the coefficient of variation of the abrasive grain diameter is 20% or less.
(7) The metal polishing solution as described in any one of (1) to (6), which further comprises a compound represented by the following formula (1) or (2): 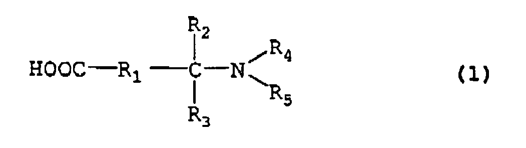 wherein R₁ represents a single bond, an alkylene group or a phenylene group,
   R₂ and R₃ each independently represents a hydrogen atom, a halogen atom, a carboxyl group, an alkyl group, a cycloalkyl group, an alkenyl group, an alkynyl group or an aryl group, and
   R₄ and R₅ each independently represents a hydrogen atom, a halogen atom, a carboxyl group, an alkyl group or an acyl group,
   provided that when R₁ is a single bond, at least one of R₄ and R₅ is not a hydrogen atom; 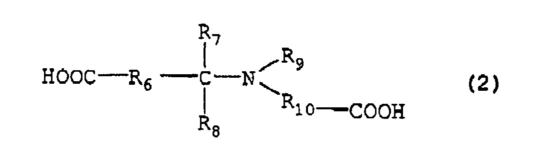 wherein R₆ represents a single bond, an alkylene group or a phenylene group,
   R₇ and R₈ each independently represents a hydrogen atom, a halogen atom, a carboxyl group, an alkyl group, a cycloalkyl group, an alkenyl group, an alkynyl group or an aryl group,
   R₉ represents a hydrogen atom, a halogen atom, a carboxyl group or an alkyl group, and
   R₁₀ represents an alkylene group,
   provided that when R₁₀ is -CH₂-, at least either R₆ is not a single bond or R₉ is not a hydrogen atom.
(8) The metal polishing solution as described in any one of (1) to (7) above, which further comprises a surfactant.
(9) The metal polishing solution as described in any one of (1) to (8), wherein the target of polishing is a semiconductor integrated circuit having an insulating material with a dielectric constant of 3 or less.
(10) The metal polishing solution as described in any one of (1) to (9), wherein the target of polishing is a semiconductor integrated circuit having a copper-containing wiring.
(11) A chemical-mechanical polishing method comprising bringing the metal polishing solution described in any one of (1) to (10) above into contact with a surface to be polished, and creating a relative motion between the surface to be polished and the polishing solution and/or a polishing pad, thereby effecting the polishing.

According to the present invention, a polishing solution capable of satisfying both a high polishing rate and a good dishing performance is provided.

### DETAILED DESCRIPTION OF THE INVENTION

The metal polishing solution of the present invention comprises an oxidizing agent, wherein assuming that the oxidation reaction rate immediately after the oxidation of a metal to be polished starts at its surface is E1 and the oxidation reaction rate when the oxidation reaction reaches the stationary state is E2, E1/E2 is 1.5 or more and the time required for reaching an oxidation reaction rate of (E1+E2)/2 is from 1 to 50 seconds.

The present inventors have found that the polishing of copper proceeds by etching, that is, oxidation and subsequent dissolution of metallic copper, and when not mere the oxidation reactivity but the time behavior of the oxidation reaction is controlled by the oxidation reaction rate E1 immediately after the oxidation of a metal to be polished starts at its surface and the oxidation reaction rate E2 when the oxidation reaction reaches the stationary state, both a high polishing rate and a good dishing performance can be achieved.

The innovative point of the present invention is in the finding that the dishing can be improved by controlling the passivation film forming rate originally having no surface shape dependency.

That is, only when the passivation film forming rate is in a specific range, the polishing rate can be discriminated according to the concave and convex and on the contrary, when the passivation film forming rate deviates from this range, a difference in the polishing rate according to the surface shape (concave and convex) is not produced.

### <Measuring Method of E1 and E2>

The oxidation reaction on the metal surface can be evaluated by electrochemically measuring the corrosion current and in the present invention, the oxidation reaction rate E1 immediately after the oxidation of a metal to be polished starts at its surface and the oxidation reaction rate E2 when the oxidation reaction reaches the stationary state can be determined by an electrochemical analysis method.

The measurement temperature is a temperature at the actual polishing but since the temperature during polishing is generally from 30 to 50°C, for the sake of convenience, the measurement can be performed at 40°C.

More specifically, a metal polishing solution not containing an oxidizing agent is used as the electrolyte and a metal to be polished is used as the working electrode. Also, a platinum electrode is used as the counter electrode. As for the reference electrode, a silver-silver chloride electrode is preferably used, but other reference electrodes such as saturated calomel electrode may also be used. The corrosion potentials at the time of containing an oxidizing agent and at the time of not containing an oxidizing agent are measured, and the potential difference thereof is defined as the oxidation potential by the oxidizing agent. A metal polishing solution not containing an oxidizing agent is used as the electrolyte and kept in an open circuit state and then, by applying a voltage corresponding to the oxidation potential by the oxidizing agent, the corrosion current value and its time change are measured on the sub-second level.

The oxidation reaction rate (nm/min) can be determined from the corrosion current density (A/cm²) and the density (g/cm²) of a metal to be polished.

Assuming that the "immediately after" is 100 milliseconds after the application of voltage and the "stationary state" is 100 seconds after the application of voltage, the oxidation reaction rate E1 immediately after the oxidation of the metal to be polished starts at its surface and the oxidation reaction rate E2 when the oxidation reaction reaches the stationary state are determined.

In the present invention, E1/E2 is 1.5 or more, preferably 2 or more, more preferably 4 or more, and most preferably 8 or more. The upper limit is not particularly specified.

The time necessary for the oxidation reaction rate to reach (E1+E2)/2 is from 1 to 50 seconds, preferably 2 seconds or more, more preferably 5 seconds or more, and preferably 20 seconds or less.

E2 is preferably 1.0 nm/min or less, more preferably 0.5 nm/min or less, still more preferably 0.2 nm/min or less, and E2 is preferably 0.01 nm/min or more.

The preparation of a metal polishing solution where E1/E2 is 1.5 or more, the time required for reaching an oxidation reaction rate of (E1+E2)/2 is from 1 to 50 seconds, and E2 is 1.0 nm/min or less, is described later, but this polishing solution can be preferably prepared by adding a heteroaromatic ring compound.

The heteroaromatic ring compound preferably has higher adsorptivity to the oxide of a target metal of polishing than the adsorptivity to the target metal of polishing.

For example, in the case where the target metal of polishing is copper, the heteroaromatic ring compound adsorbs to metallic copper or copper oxide to form a passivation film and suppress the oxidation reaction, but if the adsorptivity to metallic copper is higher than the adsorptivity to metal oxide, the oxidation reaction is suppressed before the oxidation reaction proceeds. On the other hand, when the adsorptivity to copper oxide is higher than the adsorptivity to metallic copper, the suppression of oxidation reaction is weak at the initial stage of oxidation reaction but the compound adsorbs to the copper ion oxidized in the progress of oxidation reaction and therefore, the oxidation reaction is suppressed along with the progress of oxidation reaction.

The adsorptivity to metallic copper or copper oxide can be measured by the following method.

A metallic copper or copper oxide particle having a known surface area, of which surface is treated with dilute sulfuric acid, is dispersed in water and by adding a heteroaromatic ring compound at a predetermined concentration, the amount of adsorption is measured. At this time, the surface area of the metallic copper particle is made equal to the surface area of the copper oxide particle. The amount of adsorption is measured, for example, by a method of determining the concentration of the non-adsorbed heteroaromatic ring compound from the supernatant and subtracting the determined amount from the added amount, or a method of dissolving a metallic copper or copper oxide particle with dilute sulfuric acid or the like and determining the amount of adsorption from the heteroaromatic ring concentration in the resulting solution. The adsorption selectivity to metallic copper or copper oxide can be expressed by a ratio between respective amounts of adsorption. In the present invention, the heteroaromatic ring compound preferably more adsorbable to copper oxide than to metallic copper, that is, the adsorption selectivity of copper oxide/metallic copper is preferably more than 1, more preferably more than 5.

In order to elevate the adsorption selectivity of copper oxide/metallic copper, logP of the heteroaromatic ring compound is preferably from -3.0 to 1.0, more preferably from -2.0 to -0.5.

The logP value means a common logarithm of the partition coefficient P and this is a physical value expressing how a certain organic compound is dispensed in the equilibrium of a two-phase system of oil and water, by a quantitative numerical value. When the value is larger on the plus side from 0, this means that the oil solubility is increased, and when the absolute value is larger on the minus side, this means that the water solubility is increased.

The logP value used in the present invention is determined by the calculation described below. That is, the value is determined by a program developed by medchem Project of C. Hansch, A. Leo, et al. of Pomona College in U.S.A. for estimating the logP (=log(Coil/Cwater), wherein Coil is a molar concentration in the oil phase, and Cwater is a molar concentration in the water phase). This program is based on the Hansch-Leo fragmental method where a chemical structure is divided into partial structures (fragments) and the logP value is estimated by summing the contributions from the common logarithms (logP) of the partition coefficients assigned to the fragments, and this is described in detail, for example, in C. Hansch & A. Leo, Substituent Constants for Correlation Analysis in Chemistry and Biology, and A.J. Leo, "Calculating logPoct from structure", Chem. Rev., 93, 1581-1306 (1993).

The heteroaromatic ring compound in the abrasive solution is preferably deprotonated and negatively ionized, and the pKa is preferably smaller by 2 or more than the pH of the abrasive solution.

Specific examples of the heteroaromatic ring compound include the heteroaromatic ring compounds described later for the compound having an aromatic ring. Particularly, tetrazoles represented by formula (I) or a derivative thereof and anthranilic acids represented by formula (II) or a derivative thereof are preferred.

In the present invention, for creating a change in the polishing rate according to the surface shape (concave and convex), it is effective to control the passivation film removing rate in addition to the control of the passivation film forming rate. When the time required for reaching (E1+E2)/2 is in the range of the present invention, the abrasive grain concentration is preferably 2 mass% (weight%) or less, more preferably 1 mass% or less, and most preferably 0.5 mass% or less. It is also preferred to contain substantially no abrasive grain.

The average size (average diameter) of the abrasive grain is preferably 50 nm or less, more preferably 30 nm or less, and preferably 5 nm or less. The coefficient of variation of the abrasive grain size is preferably 20% or less, more preferably 10% or less.

In order to decrease the defect such as polishing scratch, the polishing is preferably performed at a low polishing pressure of about 1 psi or less. The passivation film removing rate is considered to decrease as the polishing pressure becomes lower, and the passivation film forming rate is preferably decreased in proportion thereto.

The composition of the metal polishing solution is described below but is not limited thereto.

Incidentally, the "metal polishing solution" as used in the present invention includes not only a polishing solution on use for polishing (that is, a polishing solution diluted as needed) but also a concentrated solution of the metal polishing solution. The concentrated solution or concentrated polishing solution means a polishing solution prepared to a higher solute concentration than the polishing solution on use for polishing and is used for polishing by diluting it with water or an aqueous solution. The dilution fold is generally from 1 to 20 times by volume. In the present invention, the terms "concentrated" and "concentrated solution" are used to mean "thicker" and "thicker solution" than the state on use according to the commonly-used expression and differ from the general meanings associated with a physical concentration operation such as evaporation.

The metal polishing solution of the present invention comprises at least an oxidizing agent as the constituent component and is usually in the form of an aqueous solution.

The metal polishing solution of the present invention may further comprise other components, and preferred examples of the component include an abrasive grain, a compound added as a so-called coat-forming agent, a surfactant, a water-soluble polymer and an additive.

The components which are incorporated into the metal polishing solution may be used individually or in combination of two or more thereof.

Also, the oxidizing agent may be added immediately before use to a composition containing other components to prepare a polishing solution.

### [Oxidizing Agent]

The metal polishing solution of the present invention comprises a compound (oxidizing agent) capable of oxidizing a metal as the target of polishing.

Examples of the oxidizing agent include hydrogen peroxide, peroxide, nitrate, iodate, periodate, hypochlorite, chlorite, chlorate, perchlorate, persulfate, bichromate, permanganate, ozone water, silver(II) salt and iron(III) salt.

As for the iron(III) salt, for example, an inorganic iron(III) salt such as iron(III) nitrate, iron(III) chloride, iron(III) sulfate and iron(III) bromide, and an organic complex salt of iron(III) are preferably used.

In the case of using an organic complex salt of iron(III), examples of the complex-forming compound constituting the iron(III) complex salt include acetic acid, citric acid, oxalic acid, salicylic acid, diethyldithio-carbamic acid, succinic acid, tartaric acid, glycolic acid, glycine, alanine, aspartic acid, thioglycolic acid, ethylenediamine, trimethylenediamine, diethylene glycol, triethylene glycol, 1,2-ethanediol, malonic acid, glutaric acid, 3-hydroxybutyric acid, propionic acid, phthalic acid, isophthalic acid, 3-hydroxysalicylic acid, 3,5-dihydroxysalicylic acid, gallic acid, benzoic acid and maleic acid, or a salt thereof; and aminopolycarboxylic acid or a salt thereof.

Examples of the aminopolycarboxylic acid or a salt thereof include ethylenediamine-N,N,N',N'-tetraacetic acid, diethylenetriaminepentaacetic acid, 1,3-diaminopropane-N,N,N'N'-tetraacetic acid, 1,2-diaminopropane-N,N,N',N'-tetraacetic acid, ethylenediamine-N,N'-disuccinic acid (racemic form), ethylenediaminedisuccinic acid (SS form), N-(2-carboxylatoethyl)-L-aspartic acid, N-(carboxymethyl)-L-aspartic acid, β-alaninediacetic acid, methyliminodiacetic acid, nitrilotriacetic acid, cyclohexanediaminetetraacetic acid, iminodiacetic acid, glycol ether diaminetetraacetic acid, ethylenediamine 1-N,N'-diacetic acid, ethylenediamineorthohydroxyphenylacetic acid and N,N-bis(2-hydroxybenzyl)ethylenediamine-N,N-diacetic acid, or a salt thereof. As for the kind of the counter salt, an alkaline metal salt and an ammonium salt are preferred, and an ammonium salt is more preferred.

Among these compounds, hydrogen peroxide, iodate, hypochlorite, chlorate and an organic complex salt of iron(III) are preferred. In the case of using an organic complex salt of iron(III), preferred examples of the complex-forming compound include citric acid, tartaric acid and aminopolycarboxylic acid (specifically, ethylenediamine-N,N,N',N'-tetraacetic acid, diethylenetriaminepentaacetic acid, 1,3-diaminopropane-N,N,N' ,N'-tetraacetic acid, ethylenediamine-N,N'-disuccinic acid (racemic form), ethylenediaminedisuccinic acid (SS form), N-(2-carboxylatoethyl)-L-aspartic acid, N-(carboxymethyl)-L-aspartic acid, β-alaninediacetic acid, methyliminodiacetic acid, nitrilotriacetic acid and iminodiacetic acid).

Among these oxidizing agents, most preferred are hydrogen peroxide and an ethylenediamine-N,N,N',N'-tetraacetic acid, 1,3-diaminopropane-N,N,N',N'-tetraacetic acid or ethylenediaminedisuccinic acid (SS form) complex of iron(III).

The amount of the oxidizing agent added is preferably from 0.003 to 8 mol, more preferably from 0.03 to 6 mol, still more preferably from 0.1 to 4 mol, per liter of the metal polishing solution on use for polishing. That is, the amount of the oxidizing agent added is preferably 0.003 mol or more from the standpoint of achieving sufficient oxidation of a metal and ensuring a high CMP rate and preferably 8 mol or less in view of preventing the polished surface from roughening.

### [Compound Represented by Formula (1) or (2)]

The polishing solution preferably comprises a compound represented by formula (1) or (2): 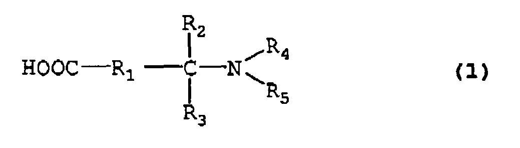 wherein R₁ represents a single bond, an alkylene group or a phenylene group,
R₂ and R₃ each independently represents a hydrogen atom, a halogen atom, a carboxyl group, an alkyl group, a cycloalkyl group, an alkenyl group, an alkynyl group or an aryl group, and
R₄ and Rs each independently represents a hydrogen atom, a halogen atom, a carboxyl group, an alkyl group or an acyl group,
provided that when R₁ is a single bond, at least one of R₄ and R₅ is not a hydrogen atom; 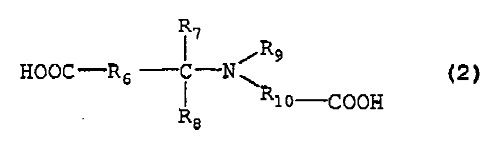 wherein R₆ represents a single bond, an alkylene group or a phenylene group,
R₇ and R₈ each independently represents a hydrogen atom, a halogen atom, a carboxyl group, an alkyl group, a cycloalkyl group, an alkenyl group, an alkynyl group or an aryl group,
R₉ represents a hydrogen atom, a halogen atom, a carboxyl group or an alkyl group, and
R₁₀ represents an alkylene group,
provided that when R₁₀ is -CH₂-, at least either R₆ is not a single bond or R₉ is not a hydrogen atom.

The alkylene group as R₁ in formula (1), which may be linear, branched or cyclic, is preferably an alkylene group having a carbon number of 1 to 8, and examples thereof include a methylene group and an ethylene group.

Examples of the substituent which the alkylene group may have include a hydroxyl group and a halogen atom.

The alkyl group as R₂ and R₃ is preferably an alkyl group having a carbon number of 1 to 8, and examples thereof include a methyl group and a propyl group.

The cycloalkyl group as R₂ and R₃ is preferably a cycloalkyl group having a carbon number of 5 to 15, and examples thereof include a cyclopentyl group, a cyclohexyl group and a cyclooctyl group.

The alkenyl group as R₂ and R₃ is preferably an alkenyl group having a carbon number of 2 to 9, and examples thereof include a vinyl group, a propenyl group and an allyl group.

The alkynyl group as R₂ and R₃ is preferably an alkynyl group having a carbon number of 2 to 9, and examples thereof include an ethynyl group, a propynyl group and a butynyl group.

The aryl group as R₂ and R₃ is preferably an aryl group having a carbon number of 6 to 15, and examples thereof include a phenyl group.

The alkylene chain in these groups may have a heteroatom such as oxygen atom and sulfur atom.

Examples of the substituent which each group as R₂ and R₃ may have include a hydroxyl group, a halogen atom, an aromatic ring (preferably having a carbon number of 3 to 15), a carboxyl group and an amino group.

The alkyl group as R₄ and R₅ is preferably an alkyl group having a carbon number of 1 to 8, and examples thereof include a methyl group and an ethyl group.

The acyl group is preferably an acyl group having a carbon number of 2 to 9, and examples thereof include a methylcarbonyl group.

Examples of the substituent which each group as R₄ and R₅ may have include a hydroxyl group, an amino group and a halogen atom.

As for R₄ and R₅, R₄ is preferably a group represented by L₁-R₄₁, and R₅ is preferably a group represented by L₂-R₅₁, wherein L₁ and L₂ each is an alkylene group, a group represented by -((CH₂)₁O)ₘ- or a group represented by -CO(CH₂)ₙ- (wherein 1 is an integer of 1 to 3, m is an integer of 1 to 3, and n is an integer of 1 to 3), and R₄₁ and R₅₁ each is a hydrogen atom, a hydroxyl group or an amino group.

In formula (1), either one of R₄ and R₅ is preferably not a hydrogen atom.

In formula (1), it is preferred that R₁ is a single bond and R₂ and R₄ each is a hydrogen atom. In this case, R₃ which represents a hydrogen atom, a halogen atom, a carboxyl group, an alkyl group, a cycloalkyl group, an alkenyl group, an alkynyl group or an aryl group, is preferably a hydrogen atom or an alkyl group, and R₅ which represents a hydrogen atom, a halogen atom, a carboxyl group, an alkyl group or an acyl group, is preferably an alkyl group. The substituent which the alkyl group as R₃ may have is preferably a hydroxyl group, a carboxyl group or an amino group, and the substituent which the alkyl group as R₅ may have is preferably a hydroxyl group or an amino group.

The alkylene group as R₆ and R₁₀ in formula (2), which may be linear, branched or cyclic, is preferably an alkylene group having a carbon number of 1 to 8, and examples thereof include a methylene group and an ethylene group.

Examples of the substituent which the alkylene group and phenylene group may have include a hydroxyl group and a halogen atom.

The alkyl group as R₇ and R₈ is preferably an alkyl group having a carbon number of 1 to 8, and examples thereof include a methyl group and a propyl group.

The cycloalkyl group as R₇ and Rₑ is preferably a cycloalkyl group having a carbon number of 5 to 15, and examples thereof include a cyclopentyl group, a cyclohexyl group and a cyclooctyl group.

The alkenyl group as R₇ and R₈ is preferably an alkenyl group having a carbon number of 2 to 9, and examples thereof include a vinyl group, a propenyl group and an allyl group.

The alkynyl group as R₇ and R₈ is preferably an alkynyl group having a carbon number of 2 to 9, and examples thereof include an ethynyl group, a propynyl group and a butynyl group.

The aryl group as R₇ and R₈ is preferably an aryl group having a carbon number of 6 to 15, and examples thereof include a phenyl group.

The alkylene chain in these groups may have a heteroatom such as oxygen atom and sulfur atom.

Examples of the substituent which each group as R₇ and R₈ may have include a hydroxyl group, a halogen atom and an aromatic ring (preferably having a carbon number of 3 to 15).

The alkyl group as R₉ is preferably an alkyl group having a carbon number of 1 to 8, and examples thereof include a methyl group and an ethyl group.

The alkylene chain in these groups may have a heteroatom such as oxygen atom and sulfur atom.

Examples of the substituent which each group as R₉ may have include a hydroxyl group, an amino group, a halogen atom and a carboxyl group.

In formula (2), R₉ is preferably not a hydrogen atom.

Specific examples of the compounds represented by formulae (1) and (2) are set forth below, but the present invention is not limited thereto.

**Table 1**

| | | | | | |
|---|---|---|---|---|---|
| 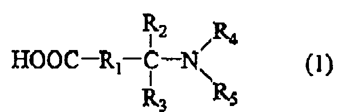 | | | | | |

| | R₁ | R₂ | R₃ | R₄ | R₅ |
|---|---|---|---|---|---|
| A-1 | - | -H | -H | -H | -CH₃ |
| A-2 | ― | -H | -H | -H | -CH₂OH |
| A-3 | ― | -H | -H | -CH₂OH | -CH₂OH |
| A-4 | ― | -H | -H | -H | -CH₂CH₂OH |
| A-5 | - | -H | -H | CH₂CH₂OH | -CH₂CH₂OH |
| A-6 | - | -H | -CH₃ | -H | -CH₂OH |
| A-7 | ― | -H | ―CH3 | ―CH₂CH₂OH | ―CH₂CH₂OH |
| A-8 | ― | -H | -CH₂OH | -H | ―CH₂OH |
| A-9 | - | -H | ―CH(CH₃)₂ | ―CH₂OH | ―CH₂OH |
| A-10 | - | -H | -Ph | -H | 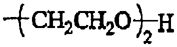 |
| A-11 | ― | -H | 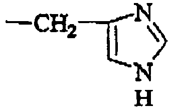 | ―CH₂CH₂OH | ―CH₂CH₂OH |
| A-12 | ― | -H | -CH₂SCH₃ | ―CH₂CH₂OH | ―CH₂CH₂OH |
| A-13 | ― | -H | -H | -H | -COCH₂NH₂ |
| A-14 | - | -H | -CH₂OH | -H | -COCH₂NH₂ |
| A-15 | - | -H | -H | -H | -COCH₃ |
| A-16 | -CH₂- | -H | -H | -CH₂CH₂OH | -CH₂CH₂OH |
| A-17 | -CH₂- | -H | -H | -H | -CH₂OH |
| A-18 | -CH₂- | -H | -H | -H | -COCH₂NH₂ |
| A-19 | -CH₂CH₂- | -H | -H | -H | -H |
| A-20 | - | -H | -CH₃ | -H | -CH₂CH₂OH |
| A-21 | - | -H | -CH₃ | -H | -CH₂OH |
| A-22 | - | -H | -CH₂CH₃ | -H | -CH₂CH₂OH |
| A-23 | - | -H | -CH₃ | -H | -CH₂OH |
| A-24 | - | -H | -CH₃ | -H | -CH₂CH₂NH₂ |
| A-25 | - | - H | CH₂(CH₃)₂ | -H | -CH₂CH₂OH |
| A-26 | - | -H | Phenyl group | -H | -CH₂CH₂OH |
| A-27 | - | -H | -H | -H | (CH2)₃OH |

**Table 2**

| | | | | | |
|---|---|---|---|---|---|
| 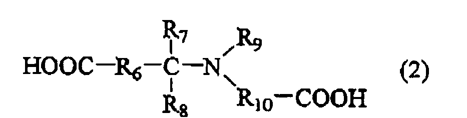 | | | | | |

| | R₆ | R₇ | R₈ | R₉ | R₁₀ |
|---|---|---|---|---|---|
| B-1 | - | -H | -H | -CH₂ | -CH₂- |
| B-2 | - | -H | -H | -CH₂OH | -CH₂- |
| B-3 | - | -H | -H | -CH₂CH₂OH | -CH₂- |
| B-4 | - | -H | -H | 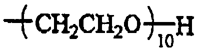 | -CH₂- |
| B-5 | - | -H | -CH₃ | -H | 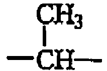 |
| B-6 | - | -H | -CH₂OH | -H | 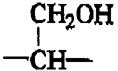 |
| B-7 | -CH₂- | -H | -H | -H | -CH₂- |
| B-8 | -CH₂- | -H | -H | -H | -CH₂CH₂- |
| B-9 | -CH₂- | -H | -H | -CH₂CH₂OH | -CH₂CH₂- |
| B-10 | -CH₂- | -H | -H | -CH₂COOH | -CH₂- |
| B-11 | - | -H | -CH₃ | -H | -CH₂CH₂- |

The compound represented by formula (1) or (2) may be synthesized by a known method, but a commercially available product may also be used.

The amount added of the compound represented by formula (1) or (2) is, in terms of the total amount, preferably from 0.0005 to 5 mol, more preferably from 0.01 to 0.5 mol, per liter of the metal polishing solution on use for polishing.

Both a compound represented by formula (1) and a compound represented by formula (2) are preferably used in combination. In this case, the ratio (compound represented by formula (1)/Compound represented by formula (2)) is, in terms of the mass ratio, generally from 100/1 to 1/100, preferably from 10/1 to 1/10.

### [Compound Having Aromatic Ring]

The metal polishing solution preferably comprises a compound having an aromatic ring.

The compound having an aromatic ring is a compound having an aromatic ring such as benzene ring and naphthalene ring, and preferably an aromatic ring compound having a molecular weight of 20 to 600. Examples thereof include tetrazoles or a derivative thereof, anthranilic acids or a derivative thereof, an aminotoluic acid, a quinaldinic acid, and the following azoles.

Examples of azoles as the compound having an aromatic ring include benzimidazole-2-thiol, 2-[2-(benzothiazolyl)]thiopropionic acid, 2-[2-(benzothiazolyl)]-thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl-1H-benzotriazole, 4-methoxycarbonyl-1H-benzotriazole, 4-butoxycarbonyl-1H-benzotriazole, 4-octyloxycarbonyl-1H-benzotriazole, 5-hexylbenzotriazole, N-(1,2,3-benzotriazolyl-1-methyl)-N-(1,2,4-triazole-1-methyl)-2-ethylhexylamine, tolyltriazole, naphthotriazole and bis[(1-benzotriazolyl)methyl]phosphonic acid. From the standpoint of satisfying both high CMP rate and low etching rate, benzotriazole, 4-hydroxybenzotriazole, 4-carboxyl-1H-benzotriazole butyl ester, tolyltriazole and naphthotriazole are preferred.

In the present invention, at least one compound selected from tetrazoles or a derivative thereof and anthranilic acids or a derivative thereof is preferably contained as the compound having an aromatic ring.

A compound represented by formula (I) is preferred as the tetrazoles or a derivative thereof, and a compound represented by formula (II) is preferred as anthranilic acids or a derivative thereof.

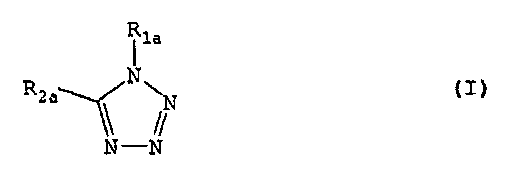

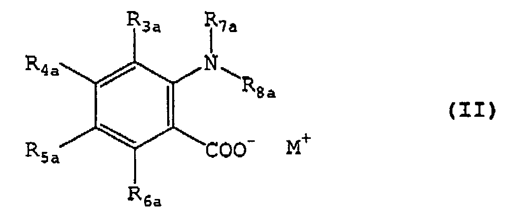

In formula (I), R₁ₐ and R₂ₐ each independently represents a hydrogen atom or a substituent, and R₁ₐ and R₂ₐ may combine with each other to form a ring, provided that when R₁ₐ and R₂ₐ both are a hydrogen atom, the compound represented by formula (I) may be a tautomer thereof.

In formula (II), R₃ₐ to R₈ₐ each independently represents a hydrogen atom or a substituent, adjacent two members out of R₃ₐ to R₆ₐ may combine with each other to form a ring, and M⁺ represents a cation.

The substituent as R₁ₐ and R₂ₐ in formula (I) is not particularly limited, but examples thereof include the followings:
a halogen atom (fluorine atom, chlorine atom, bromine atom, iodine atom), an alkyl group (which is a linear, branched or cyclic alkyl group and may be a polycyclic alkyl group such as bicycloalkyl group or may contain an active methine group), an alkenyl group, an alkynyl group, an aryl group, a heterocyclic group (the position to be substituted is not limited), an acyl group, an alkoxycarbonyl group, an aryloxycarbonyl group, a heterocyclic oxycarbonyl group, a carbamoyl group (examples of the carbamoyl group having a substituent include an N-hydroxycarbamoyl group, an N-acylcarbamoyl group, an N-sulfonylcarbamoyl group, an N-carbamoylcarbamoyl group, a thiocarbamoyl group and an N-sulfamoylcarbamoyl group), a carbazoyl group, a carboxy group or a salt thereof, an oxalyl group, an oxamoyl group, a cyano group, a carbonimidoyl group, a formyl group, a hydroxy group, an alkoxy group (including a group having an ethyleneoxy or propyleneoxy group repeating unit), an aryloxy group, a heterocyclic oxy group, an acyloxy group, an (alkoxy or aryloxy)carbonyloxy group, a carbamoyloxy group, a sulfonyloxy group,
an amino group, an (alkyl, aryl or heterocyclic)amino group, an acylamino group, a sulfonamido group, a ureido group, a thioureido group, an N-hydroxyureido group, an imido group, an (alkoxy or aryloxy)carbonylamino group, a sulfamoylamino group, a semicarbazido group, a thiosemi-carbazido group, a hydrazino group, an ammonio group, an oxamoylamino group, an N-(alkyl or aryl)sulfonylureido group, an N-acylureido group, an N-acylsulfamoylamino group, a hydroxyamino group, a nitro group, a quaternized nitrogen atom-containing heterocyclic group (e.g., pyridinio, imidazolio, quinolinio, isoquinolinio), an isocyano group, an imino group, a mercapto group, an (alkyl, aryl or heterocyclic) thio group, an (alkyl, aryl or heterocyclic)-dithio group, an (alkyl or aryl)sulfonyl group, an (alkyl or aryl)sulfinyl group, a sulfo group or a salt thereof, a sulfamoyl group (examples of the sulfamoyl group having a substituent include an N-acylsulfamoyl group and an N-sulfonylsulfamoyl group) or a salt thereof, a phosphino group, a phosphinyl group, a phosphinyloxy group, a phosphinylamino group and a silyl group.

Incidentally, the "active methine group" means a methine group substituted by two electron-withdrawing groups, and the "electron-withdrawing group" means, for example, an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group or a carbonimidoyl group. The two electron-withdrawing groups may take a cyclic structure by combining with each other. Also, the "salt" means a cation of alkali metal, alkaline earth metal, heavy metal or the like, or an organic cation such as ammonium ion and phosphonium ion.

Among these substituents, preferred examples include a halogen atom (fluorine atom, chlorine atom, bromine atom, iodine atom), an alkyl group (which is a linear, branched or cyclic alkyl group and may be a polycyclic alkyl group such as bicycloalkyl group or may contain an active methine group), an alkenyl group, an alkynyl group, an aryl group, a heterocyclic group (the position to be substituted is not limited), an acyl group, an alkoxycarbonyl group, an aryloxycarbonyl group, a heterocyclic oxycarbonyl group, a carbamoyl group, an N-hydroxycarbamoyl group, an N-acylcarbamoyl group, an N-sulfonylcarbamoyl group, an N-carbamoylcarbamoyl group, a thiocarbamoyl group, an N-sulfamoylcarbamoyl group, a carbazoyl group, an oxalyl group, an oxamoyl group, a cyano group, a carbonimidoyl group, a formyl group, a hydroxy group, an alkoxy group (including a group having an ethyleneoxy or propyleneoxy group repeating unit), an aryloxy group, a heterocyclic oxy group, an acyloxy group, an (alkoxy or aryloxy) carbonyloxy group, a carbamoyloxy group, a sulfonyloxy group, an (alkyl, aryl or heterocyclic)amino group, an acylamino group, a sulfonamido group, a ureido group, a thioureido group, an N-hydroxyureido group, an imido group,
an (alkoxy or aryloxy)carbonylamino group, a sulfamoylamino group, a semicarbazido group, a thiosemi-carbazido group, a hydrazino group, an ammonio group, an oxamoylamino group, an N-(alkyl or aryl)sulfonylureido group, an N-acylureido group, an N-acylsulfamoylamino group, a hydroxyamino group, a nitro group, a quaternized nitrogen atom-containing heterocyclic group (e.g., pyridinio, imidazolio, quinolinio, isoquinolinio), an isocyano group, an imino group, a mercapto group, an (alkyl, aryl or heterocyclic)thio group, an (alkyl, aryl or heterocyclic)-dithio group, an (alkyl or aryl)sulfonyl group, an (alkyl or aryl) sulfinyl group, a sulfo group or a salt thereof, a sulfamoyl group, an N-acylsulfamoyl group, an N-sulfonylsulfamoyl group or a salt thereof, a phosphino group, a phosphinyl group, a phosphinyloxy group, a phosphinylamino group and a silyl group. Incidentally, the "active methine group" as used herein means a methine group substituted by two electron-withdrawing groups, and examples of the electron-withdrawing group include an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group and a carbonimidoyl group.

More preferred examples of the substituent include a halogen atom (fluorine atom, chlorine atom, bromine atom, iodine atom), an alkyl group (which is a linear, branched or cyclic alkyl group and may be a polycyclic group such as bicycloalkyl group or may contain an active methine group), an alkenyl group, an alkynyl group, an aryl group and a heterocyclic group (the position to be substituted is not limited).

The ring formed together with the -C-N- bond in formula (I) after R₁ₐ and R₂ₐ are combined, which may be monocyclic or polycyclic, is preferably a 5- or 6-membered monocyclic ring or a polycyclic ring consisting of a 5- or 6-membered ring.

These substituents each may be further substituted by the above-described substituent.

The molecular weight of the compound represented by formula (I) is preferably from 20 to 600, more preferably from 40 to 400.

Specific examples of the compound represented by formula (I) are set forth below, but the present invention is not limited thereto.

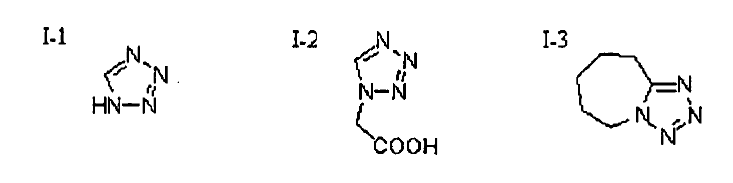

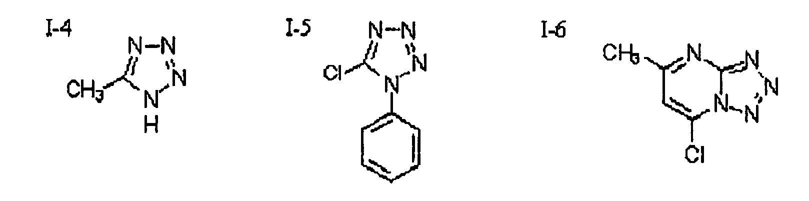

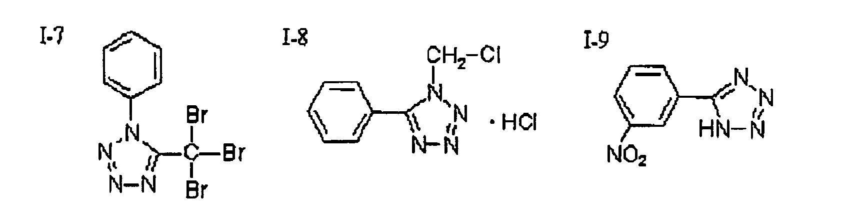

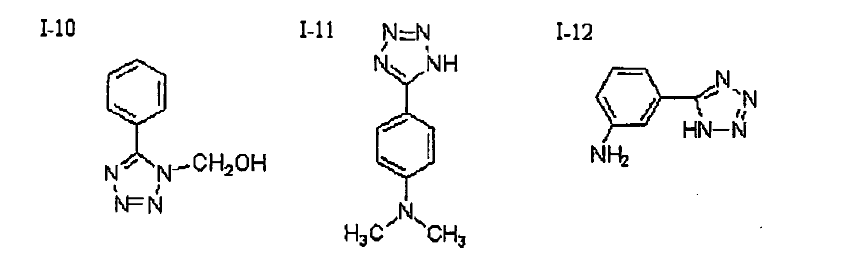

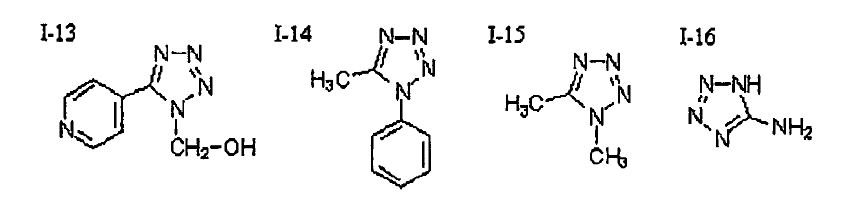

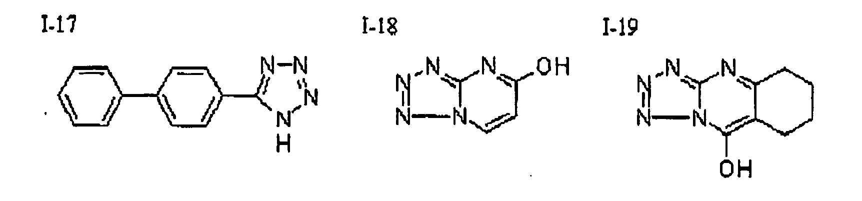

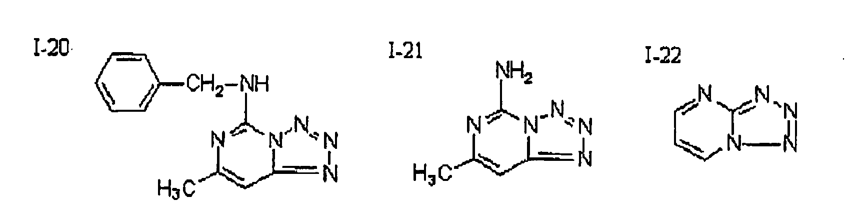

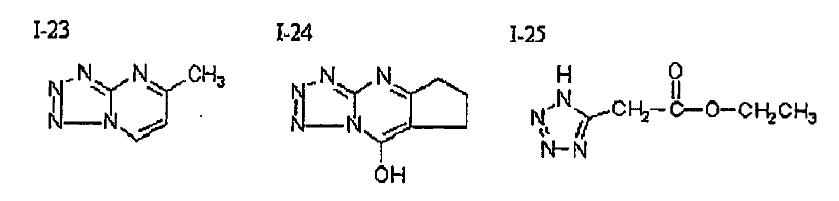

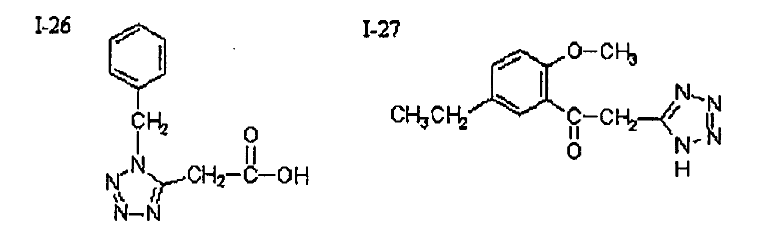

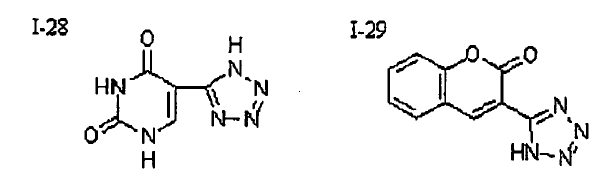

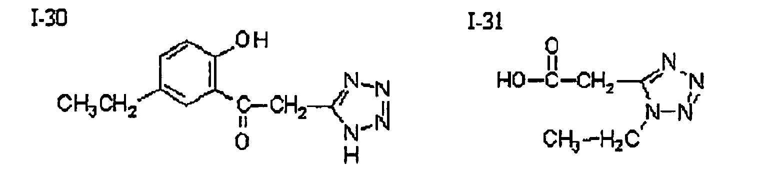

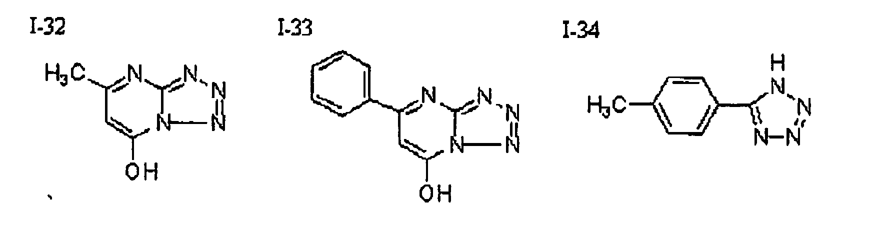

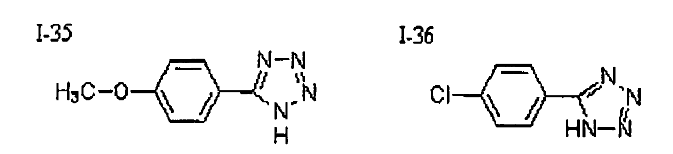

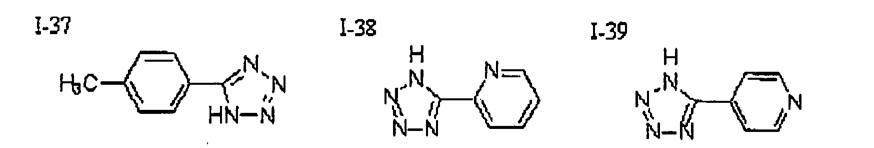

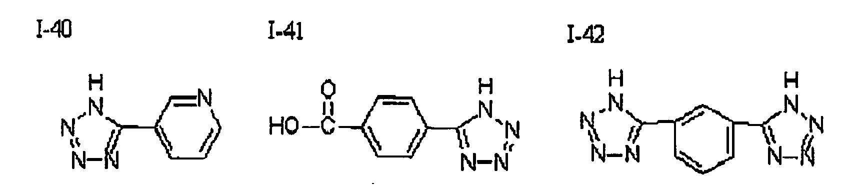

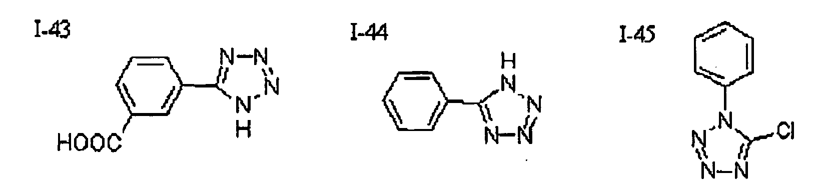

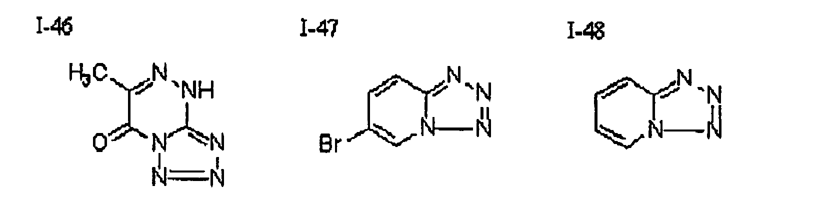

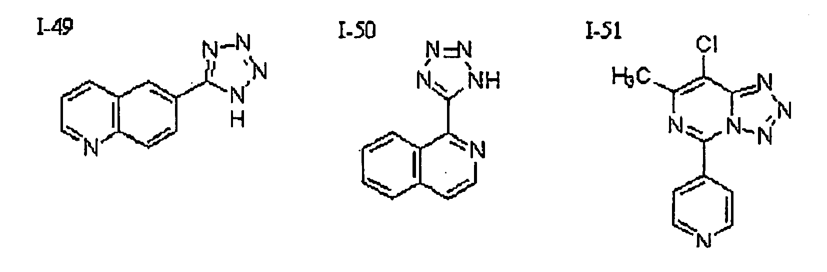

Among the compounds represented by formula (I), preferred are Compounds I-1, I-3, I-4, I-10, 1-15, I-21, I-22, I-23, I-41 and I-48, more preferred are Compounds I-1, I-4, I-15, I-22 and I-23.

The compound represented by formula (I) may be synthesized according to an ordinary method or may be a commercially available product.

The substituent as R₃ₐ to R₈ₐ in formula (II) is not particularly limited, but examples thereof include the followings:
a halogen atom (fluorine atom, chlorine atom, bromine atom, iodine atom), an alkyl group (which is a linear, branched or cyclic alkyl group and may be a polycyclic alkyl group such as bicycloalkyl group or may contain an active methine group), an alkenyl group, an alkynyl group, an aryl group, a heterocyclic group (the position to be substituted is not limited), an acyl group, an alkoxycarbonyl group, an aryloxycarbonyl group, a heterocyclic oxycarbonyl group, a carbamoyl group (examples of the carbamoyl group having a substituent include an N-hydroxycarbamoyl group, an N-acylcarbamoyl group, an N-sulfonylearbamoyl group, an N-carbamoylcarbamoyl group, a thiocarbamoyl group and an N-sulfamoylcarbamoyl group), a carbazoyl group, a carboxy group or a salt thereof, an oxalyl group, an oxamoyl group, a cyano groups a carbonimidoyl groups a formyl group, a hydroxy group, an alkoxy group (including a group having an ethyleneoxy or propyleneoxy group repeating unit), an aryloxy group, a heterocyclic oxy group, an acyloxy group, an (alkoxy or aryloxy)carbonyloxy group, a carbamoyloxy group, a sulfonyloxy group,
an amino group, an (alkyl, aryl or heterocyclic)amino group, an acylamino group, a sulfonamido group, a ureido group, a thioureido group, an N-hydroxyureido group, an imido group, an (alkoxy or aryloxy)carbonylamino group, a sulfamoylamino group, a semicarbazido group, a thiosemi-carbazido group, a hydrazino group, an ammonio group, an oxamoylamino group, an N-(alkyl or aryl)sulfonylureido group, an N-acylureido group, an N-acylsulfamoylamino group, a hydroxyamino group, a nitro group, a quaternized nitrogen atom-containing heterocyclic group (e.g., pyridinio, imidazolio, quinolinio, isoquinolinio), an isocyano group, an imino group, a mercapto group, an (alkyl, aryl or heterocyclic)thio group, an (alkyl, aryl or heterocyclic)-dithio group, an (alkyl or aryl)sulfonyl group, an (alkyl or aryl)sulfinyl group, a sulfo group or a salt thereof, a sulfamoyl group (examples of the sulfamoyl group having a substituent include an N-acylsulfamoyl group and an N-sulfonylsulfamoyl group) or a salt thereof, a phosphino group, a phosphinyl group, a phosphinyloxy group, a phosphinylamino group and a silyl group.

Incidentally, the "active methine group" means a methine group substituted by two electron-withdrawing groups, and the "electron-withdrawing group" means, for example, an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group or a carbonimidoyl group. The two electron-withdrawing groups may take a cyclic structure by combining with each other. Also, the "salt" means a cation of alkali metal, alkaline earth metal, heavy metal or the like, or an organic cation such as ammonium ion and phosphonium ion.

These substituents each may be further substituted by such a substituent.

Among these substituents, preferably, at least one of R₃ₐ to R₆ₐ is a substituent excluding an alkyl group and not having a substituent; more preferably, R₇ₐ to R₈ₐ each is a hydrogen atom; still more preferably, at least one of R₃ₐ to R₆ₐ is the above-described electron-withdrawing group and at the same time, R₇ₐ and R₈ₐ each is a hydrogen atom.

The cation as M⁺ is not particularly limited, but examples thereof include a hydrogen ion, an alkali metal ion (e.g., Na⁺, K⁺, Li⁺) and an ammonium ion (e.g., NH₄⁺, quaternary ammonium ion).

The molecular weight of the compound represented by formula (II) is preferably from 20 to 600, more preferably from 40 to 400.

Specific examples of the compound represented by formula (II) are set forth below, but the present invention is not limited thereto.

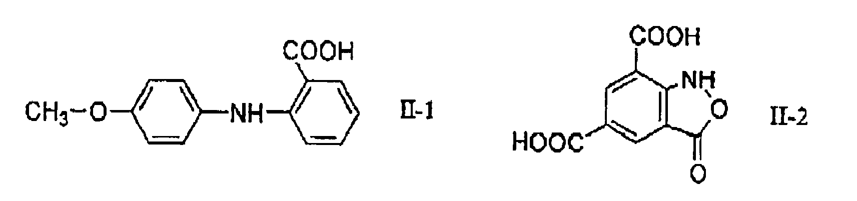

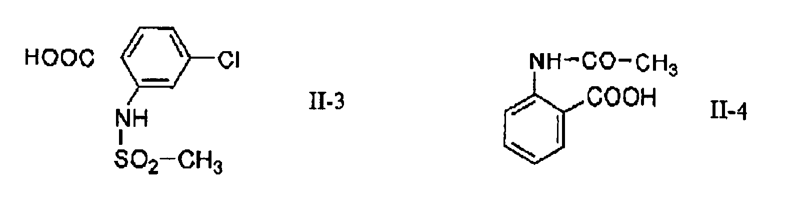

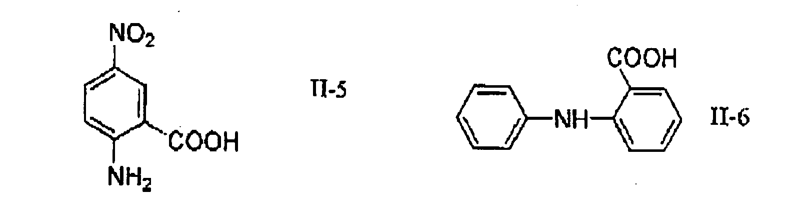

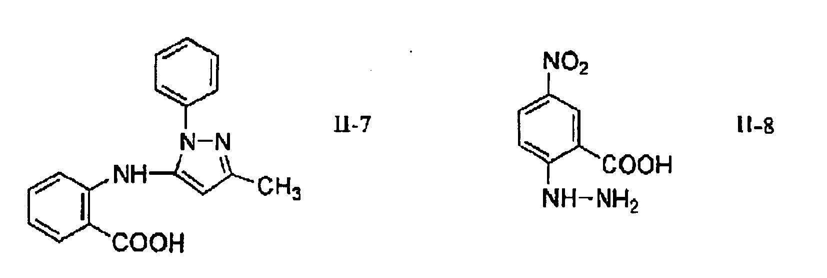

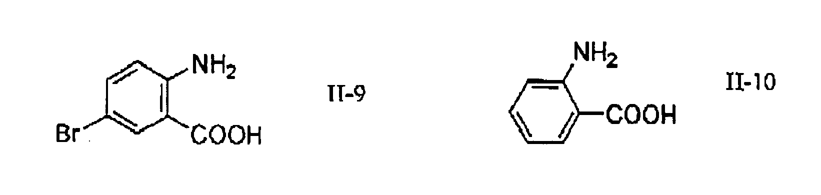

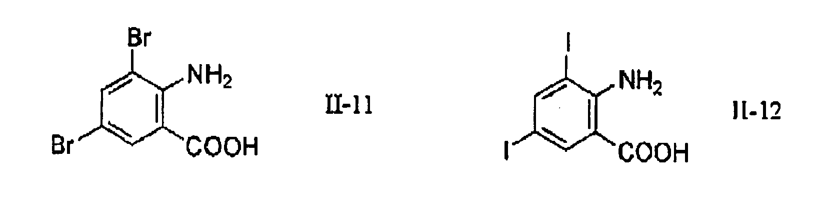

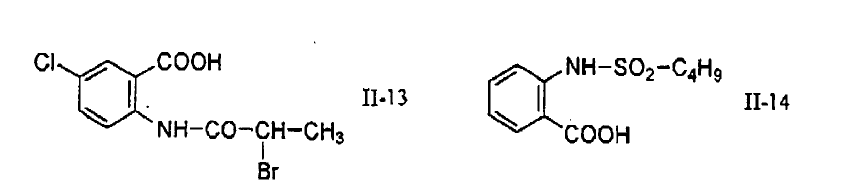

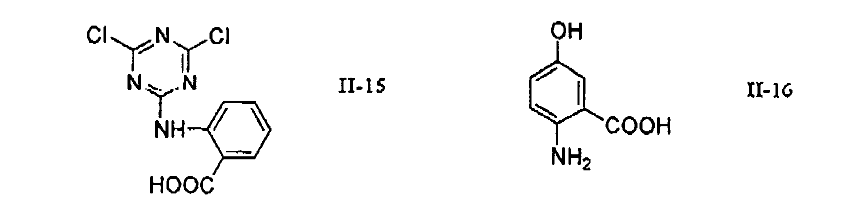

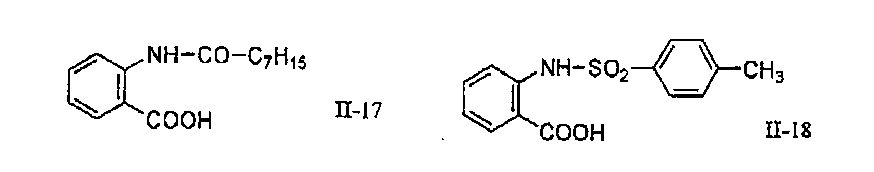

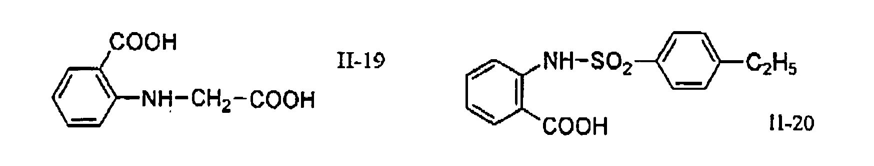

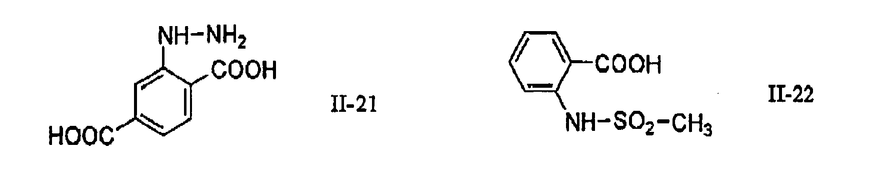

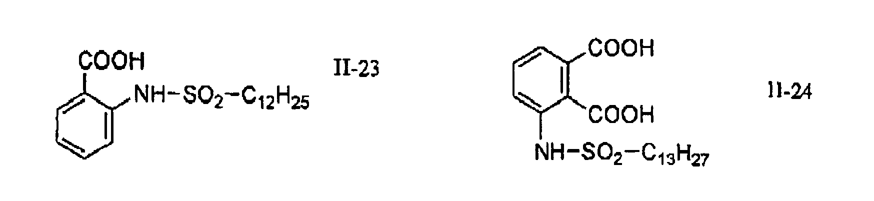

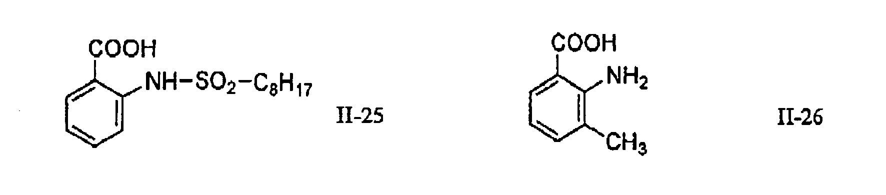

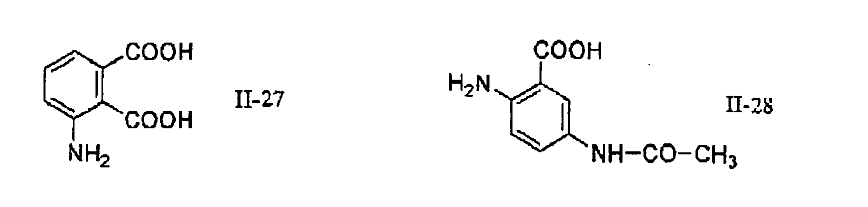

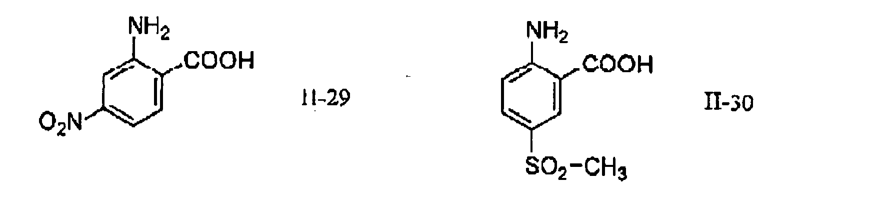

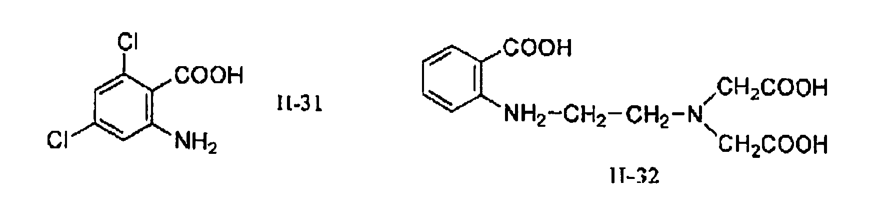

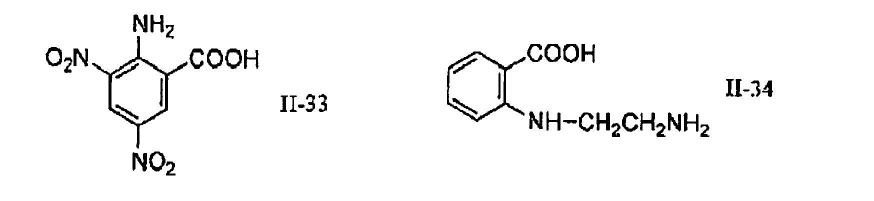

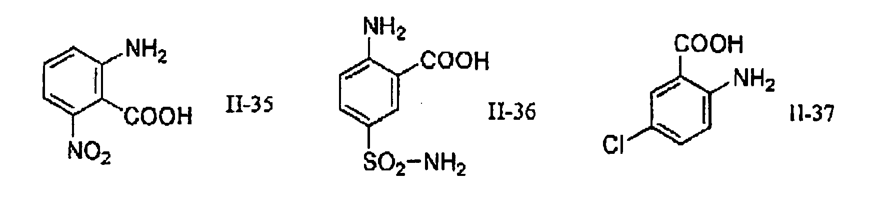

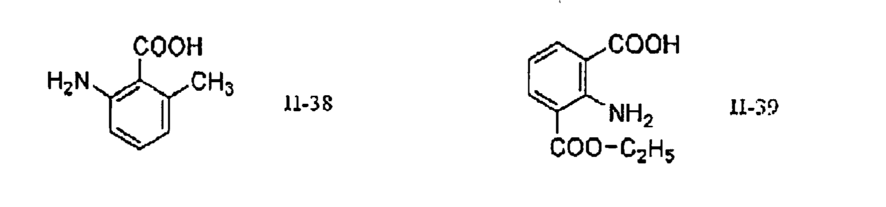

Among these compounds, preferred are Compounds II-2, II-5, II-9, II-27, II-29, II-30, II-33, II-35 and II-37, more preferred are Compounds II-5, II-9, II-27, II-29 and II-33.

Other examples include a salt resulting from substituting a hydrogen atom of the carboxyl group in the compounds set forth above by an alkali metal ion (e.g., Na⁺, K⁺, Li⁺) or an ammonium ion (e.g., NH⁺, quaternary ammonium ion).

The compounds represented by formula (II) may be used individually or in combination of two or more thereof.

The compound represented by formula (II) may be a commercially available product or may be synthesized according to an ordinary method.

For example, Compound II-29 can be synthesized in accordance with a synthesis method described in Synthesis (8), 654-659 (1983), and Compound II-37 can be synthesized in accordance with a synthesis method described in Tetrahedron Letters, 51(7), 1861-1866 (1995), and Tetrahedron Letters, 44 (25), 4741-4745 (2003). Other compounds can also be synthesized in accordance with a method described in these publications.

The amount added of the compound having an aromatic ring, such as tetrazoles or a derivative thereof and anthranilic acids or a derivative thereof, is, in terms of the total amount, preferably from 0.0001 to 1.0 mmol, more preferably from 0.001 to 0.5 mol, still more preferably from 0.01 to 0.1 mol, per liter of the metal polishing solution on use for polishing (that is, in the case of diluting the metal polishing solution with water or an aqueous solution, the diluted polishing solution; hereinafter, the same applies to the "polishing solution on use for polishing").

That is, the amount added of the compound having an aromatic ring is preferably 1.0 mol or less per liter of the polishing solution on use for polishing from the standpoint of preventing deterioration (invalidation, decomposition) of the oxidizing agent and such a compound and preferably 0.0001 mol or more for obtaining a sufficiently high effect.

Also, a thiocyanate, thioethers, a thiosulfate or a methoion compound may be used in combination in an amount smaller than the amount added of the tetrazoles and a derivative thereof or the anthranilic acids and a derivative thereof.

### [Acid]

The polishing solution of the present invention may further comprises an acid. The "acid" as used herein means a compound having a structure different from that of the oxidizing agent used for oxidizing a metal and excludes the above-described acid functioning as an oxidizing agent and the compound represented by formula (1) or (2). The acid used here has an activity of accelerating the oxidation or adjusting the pH or as a buffering agent.

Examples of the acid within this range include an inorganic acid, an organic acid and an amino acid.

Examples of the inorganic acid include sulfuric acid, nitric acid, boric acid and phosphoric acid. Among these inorganic acids, phosphoric acid is preferred.

In the present invention, the presence of an organic acid or an amino acid is preferred, and an amino acid is more preferred.

The organic acid is preferably a water-soluble organic acid and is suitably selected from the group consisting of formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, or a salt (e.g., ammonium salt, alkali metal salt) thereof, sulfuric acid, nitric acid, ammonia, ammonium salts, and a mixture thereof. Among these, formic acid, malonic acid, malic acid, tartaric acid and citric acid are suitable for a laminate film comprising at least one metal layer selected from copper, a copper alloy and an oxide of copper or copper alloy.

The amino acid is preferably a water-soluble amino acid and is suitably selected from the group consisting of amino acids such as:
glycine, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiodo-L-tyrosine, β-(3,4-dihydroxyphenyl)-L-alanine, L-thyroxine, 4-hydroxy-L-proline, L-cystine, L-methionine, L-ethionine, L-lanthionine, L-cystathionine, L-cystine, L-cysteic acid, L-aspartic acid, L-glutamic acid, s-(carboxymethyl)-L-cysteine, 4-aminobutyric acid, L-asparagine, L-glutamine, azaserine, L-arginine, L-canavanine, L-citruline, δ-hydroxy-L-lysine, creatine, L-kynurenine, L-histidine, 1-methyl-L-histidine, 3-methyl-L-histidine, ergothioneine, L-tryptophan, actinomycin C1, apamine, angiotensin I, angiotensin II and antipain.

Particularly, malic acid, tartaric acid, citric acid, glycine and glycolic acid are preferred in that the etching rate can be effectively suppressed while maintaining a practical CMP rate.

The amount of the acid added is preferably from 0.0005 to 0.5 mol, more preferably from 0.005 to 0.3 mol, still more preferably from 0.01 to 0.1 mol, per liter of the metal polishing solution on use for polishing. That is, the amount of the acid added is preferably 0.5 mol or less from the standpoint of suppressing the etching and preferably 0.0005 mol or more for obtaining a sufficiently high effect.

### [Chelating Agent]

The metal polishing solution of the present invention preferably contains a chelating agent (namely, hard water softening agent), if desired, so as to reduce the adverse effect of a polyvalent metal ion or the like mingled.

The chelating agent is a general-purpose hard water softening agent or its analogous compound, which is an anti-precipitating agent for calcium or magnesium. Examples of the chelating agent include nitrilotriacetic acid, diethylenetriaminepentaacetic acid, ethylenediaminetetraacetic acid, N,N,N-trimethylenephosphonic acid, ethylenediamine-N,N,N',N'-tetramethylenesulfonic acid, transcyclohexanediaminetetraacetic acid, 1,2-diaminopropanetetraacetic acid, glycol ether diaminetetraacetic acid, ethylenediamineorthohydroxyphenylacetic acid, ethylenediaminedisuccinic acid (SS fort), N-(2-carboxylatoethyl)-L-aspartic acid, β-alaninediacetic acid, 2-phosphonobutane-1,2,4-tricarboxylic acid, 1-hydroxyethylidene-1,1-diphosphonic acid, N,N'-bis(2-hydroxybenzyl)ethylenediamine-N,N'-diacetic acid 1,2-dihydroxybenzene-4,6-disulfonic acid.

If desired, two or more kinds of chelating agents may be used in combination.

The amount of the chelating agent added may be sufficient if it is an amount large enough to sequester a metal ion mingled, such as polyvalent metal ion. For example, the chelating agent is added to have a concentration of 0.0003 to 0.07 mol per liter of the metal polishing solution on use for polishing.

### [Additive]

The metal polishing solution of the present invention also preferably uses the following additives:
ammonia; an amine such as alkyl amine (e.g., dimethylamine, trimethylamine, triethylamine, propylenediamine), ethylenediaminetetraacetic acid (EDTA), sodium diethyldithiocarbamate and chitosan; an imine such as dithizone, cuproine (2,2'-biquinoline), neocuproine (2,9-dimethyl-1,10-phenanthroline), bathocuproine (2,9-dimethyl-4,7-diphenyl-1,10-phenanthroline) and cuprizone (biscyclo-hexanone-oxalylhydrazone) ; and a mercaptan such as nonylmercaptan, dodecylmercaptan, triazinedithiol and triazinetrithiol.

Among these, chitosan, ethylenediaminetetraacetic acid, L-tryptophan, cuprizone and triazinedithiol are preferred from the standpoint of satisfying both a high CMP rate and a low etching rate.

The amount of such an additive added is preferably from 0.0001 to 0.5 mol, more preferably from 0.001 to 0.2 mol, still more preferably from 0.005 to 0.1 mol, per liter of the metal polishing solution on use for polishing. That is, the amount of the additive added is preferably 0.0001 mol or more from the standpoint of suppressing the etching and preferably 0.5 mol or less in view of preventing the reduction of the CMP rate.

### [Surfactant and/or Hydrophilic Polymer]

The metal polishing solution of the present invention preferably contains a surfactant and/or a hydrophilic polymer. The surfactant and the hydrophilic polymer both have an activity of reducing the contact angle with the surface to be polished and accelerating uniform polishing. The surfactant and/or hydrophilic polymer used is suitably selected from the group consisting of the followings.

Examples of anionic surfactant include a carboxylate, a sulfonate, a sulfuric ester salt and a phosphoric ester salt. Examples of the carboxylate include soap, N-acylamino acid salt, polyoxyethylene or polyoxypropylene alkyl ether carboxylate and acylated peptide; examples of the sulfonate include alkyl sulfonate, alkylbenzene or alkylnaphthalene sulfonate, naphthalene sulfonate, sulfosuccinate, α-olefin sulfonate and N-acyl sulfonate; examples of the sulfuric ester salt include sulfated oil, alkyl sulfate, alkyl ether sulfate, polyoxyethylene or polyoxypropylene alkyl allyl ether sulfate and alkylamide sulfate; examples of the phosphoric ester salt include alkyl phosphate and polyoxyethylene or polyoxypropylene alkyl allyl ether phosphate.

Examples of the cationic surfactant include an aliphatic amine salt, an aliphatic quaternary ammonium salt, a benzalkonium chloride salt, a benzethonium chloride, a pyridinium salt and an imidazolinium salt; and examples of the amphoteric surfactant include a carboxybetaine type, an arninocarboxylate, an imidazolinium betaine, a lecithin and an alkylamine oxide.

Examples of the nonionic surfactant include an ether type, an ether ester type, an ester type and a nitrogen-containing type. Examples of the ether type include a polyoxyethylene alkyl or alkylphenyl ether, an alkyl allyl formaldehyde-condensed polyoxyethylene ether, a polyoxyethylene polyoxypropylene block polymer and a polyoxyethylene polyoxypropylene alkyl ether; examples of the ether ester type include a polyoxyethylene ether of glycerin ester, a polyoxyethylene ether of sorbitan ester and a polyoxyethylene ether of sorbitol ester; examples of the ester type include a polyethylene glycol fatty acid ester, a glycerin ester, a polyglycerin ester, a sorbitan ester, a propylene glycol ester and a sucrose ester; and examples of the nitrogen-containing type include a fatty acid alkanolamide, a polyoxyethylene fatty acid amide and a polyoxyethylene alkylamide.

other examples include a fluorine-containing surfactant.

Furthermore, other examples of the surfactant, hydrophilic compound, hydrophilic polymer and the like include an ester such as glycerin ester, sorbitan ester, methoxyacetic acid, ethoxyacetic acid, 3-ethoxypropionic acid and alanine ethyl ester; an ether such as polyethylene glycol, polypropylene glycol, polytetramethylene glycol, polyethylene glycol alkyl ether, polyethylene glycol alkenyl ether, alkyl polyethylene glycol, alkyl polyethylene glycol alkyl ether, alkyl polyethylene glycol alkenyl ether, alkenyl polyethylene glycol, alkenyl polyethylene glycol alkyl ether, alkenyl polyethylene glycol alkenyl ether, polypropylene glycol alkyl ether, polypropylene glycol alkenyl ether, alkyl polypropylene glycol, alkyl polypropylene glycol alkyl ether, alkyl polypropylene glycol alkenyl ether, alkenyl polypropylene glycol, alkenyl polypropylene glycol alkyl ether and alkenyl polypropylene glycol alkenyl ether; polysaccharides such as alginic acid, pectinic acid, carboxymethyl cellulose, curdlan and pullulan; an amino acid salt such as glycine ammonium salt and glycine sodium salt; a polycarboxylic acid or a salt thereof, such as polyaspartic acid, polyglutamic acid, polylycine, polymalic acid,
polymethacrylic acid, ammonium polymethacrylate, sodium polymethacrylate, polyamide acid, polymaleic acid, polyitaconic acid, polyfumaric acid, poly(p-styrene-carboxylic acid), polyacrylic acid, polyacrylamide, aminopolyacrylamide, ammonium polyacrylate, sodium polyacrylate, polyamide acid, polyamide acid anunonium salt, polyamide acid sodium salt and polyglyoxylic acid; a vinyl-based polymer such as polyvinyl alcohol, polyvinylpyrrolidone and polyacrolein; a sulfonic acid or a salt thereof, such as ammonium methyltaurate, sodium methyltaurate, sodium methyl sulfate, ammonium ethyl sulfate, ammonium butyl sulfate, sodium vinylsulfonate, sodium 1-allylsulfonate, sodium 2-allylsulfonate, sodium methoxymethyl sulfonate, ammonium ethoxymethyl sulfonate, sodium 3-ethoxypropyl sulfonate, sodium methoxymethyl sulfonate, ammonium ethoxymethyl sulfonate, sodium 3-ethoxypropyl sulfonate and sodium sulfosuccinate; and an amide such as propionamide, acrylamide, methylurea, nicotinamide, succinamide and sulfanylamide.

In this regard, however, when the substrate to which the polishing solution is applied is, for example, a silicon substrate for semiconductor integrated circuit, an acid or an ammonium salt thereof is preferred, because contamination by an, alkali metal, an alkaline earth metal, a halide or the like is undesired, but this does not apply when the substrate is a glass substrate or the like. Among the compounds described above, cyclohexanol, ammonium polyacrylate, polyvinyl alcohol, succinamide, polyvinylpyrrolidone, polyethylene glycol and a polyoxyethylene polyoxypropylene block copolymer are more preferred.

The amount added of the surfactant and/or the hydrophilic polymer is, in terms of the total amount, preferably from 0.001 to 10 g, more preferably 0.01 to 5 g, still more preferably from 0.1 to 3 g, per liter of the metal polishing solution on use for polishing. That is, the amount added of the surfactant and/or the hydrophilic polymer is preferably 0.001 g or more from the standpoint of obtaining a sufficiently high effect and preferably 10 g or less for preventing reduction of the CMP rate. Also, the weight average molecular weight of the surfactant and/or the hydrophilic polymer is preferably from 500 to 100,000, more preferably from 2,000 to 50,000.

### [Alkali Agent and Buffering Agent]

The polishing solution of the present invention may contain, if desired, an alkali agent for adjusting the pH and may further contain a buffering agent for suppressing the fluctuation of pH.

Examples of the alkali agent and buffering agent which can be used include a non-metallic alkali agent such as organic ammonium hydroxide (e.g., ammonium hydroxide, tetramethylammonium hydroxide) and alkanol amines (e.g., diethanolamine, triethanolamine, triisopropanolamine), an alkali metal hydroxide such as sodium hydroxide, potassium hydroxide and lithium hydroxide, a carbonate, a phosphate, a borate, a tetraborate, a hydroxybenzoate, a glycine salt, an N,N-dimethyl glycine salt, a leucine salt, an norleucine salt, a guanine salt, a 3,4-dihyroxyphenylalanine salt, an alanine salt, an aminobutyrate, a 2-amino-2-methyl-1,3-propanediol salt, a valine salt, a proline salt, a trishydroxyaminomethane salt and a lycine salt.

Specific examples of the alkali agent and buffering agent include sodium hydroxide, potassium hydroxide, lithium hydroxide, sodium carbonate, potassium carbonate, sodium bicarbonate, potassium bicarbonate, trisodium phosphate, tripotassium phosphate, disodium phosphate, dipotassium phosphate, sodium borate, potassium borate, sodium tetraborate (borax), potassium tetraborate, sodium o-hydroxybenzoate (sodium salicylate), potassium o-hydroxybenzoate, sodium 5-sulfo-2-hydroxybenzoate (sodium 5-sulfosalicylate), potassium 5-sulfo-2-hydroxybenzoate (potassium 5-sulfosalicylate) and ammonium hydroxide.

In particular, ammonium hydroxide, potassium hydroxide, lithium hydroxide and tetramethylammonium hydroxide are preferred as the alkali agent.

The amount added of the alkaline agent and buffering agent may be sufficient if it is an amount large enough to maintain the pH in a preferred range, and the amount added is preferably from 0.0001 to 1.0 mol, more preferably from 0.003 mol to 0.5 mol, per liter of the polishing solution on use for polishing.

The pH of the polishing solution on use for polishing is preferably from 2 to 14, more preferably from 3 to 12, and most preferably from 3.5 to 8. Within this range, the metal polishing solution of the present invention exerts a particularly excellent effect.

In the present invention, it is preferred to appropriately set the compound species, amount added or pH according to the adsorptivity to and reactivity with a polishing surface, the solubility of a metal polished, the electrochemical properties of the surface to be polished, the dissociation state of a compound functional group, the stability as a solution, and the like.

Incidentally, out of the components added at the preparation of a concentrated solution of the metal polishing solution, the blending amount of the component having a solubility of less than 5% in water at room temperature is preferably made to fall within 2 times, more preferably within 1.5 times, the solubility in water at room temperature, so that when the concentrated solution is cooled to 5°C, the precipitation can be prevented.

### [Abrasive Grain]

The metal polishing solution of the present invention preferably contains an abrasive grain. Preferred examples of the abrasive grain include silica (precipitated silica, fumed silica, colloidal silica, synthetic salica), ceria, alumina, titania, zirconia, germania, manganese oxide, silicon carbide, polystyrene, polyacryl and polytere-phthalate. In particular, colloidal silica is preferred.

The average size (diameter) of the abrasive grain is preferably 50 nm or less, more preferably from 5 to 30 nm. The coefficient of variation of the abrasive grain diameter is preferably 20% or less.

The amount of the abrasive grain added is preferably from 0 to 2 mass%, more preferably from 0.05 to 1 mass%, based on the entire mass of the metal polishing solution on use.

In the case of containing no abrasive grain or containing an abrasive grain at a concentration of less than 0.01 mass%, it has been found that properties in view of polishing rate and dishing are enhanced by setting the pH to preferably 3.5 or more, more preferably 4.0 or more. In this case, the above-described hydrophilic polymer such as polyacrylic acid is preferably added, and the amount added thereof is generally from 0.0001 to 5 mass%, preferably from 0.01 to 0.5 mass%.

### [Wiring Metal Raw Material]

In the present invention, the target of polishing is preferably a semiconductor integrated circuit having a copper-containing wiring. The copper-containing wiring is a wiring comprising a copper metal and/or a copper alloy, and a wiring comprising a copper alloy is preferred. Among the copper alloys, a copper alloy containing silver is preferred. The amount of silver contained in the copper alloy is preferably 40 mass% or less, more preferably 10 mass% or less, still more preferably 1 mass% or less. With a copper alloy having a silver content of 0.00001 to 0.1 mass%, a most excellent effect is brought out.

### [wiring Thickness]

In the present invention, the semiconductor which is a target of polishing is preferably an LSI having a wiring with a half pitch of, for example, in the DRAM device system, preferably 0.15 µm or less, more preferably 0.10 µm or less, still more preferably 0.08 µm or less, and in the MPU device system, preferably 0.12 µm or less, more preferably 0.09 µm or less, still more preferably 0.07 µm or less. The polishing solution of the present invention exerts a particularly excellent effect on such an LSI.

### [Barrier Metal]

In the present invention, a barrier layer for preventing diffusion of copper is preferably provided between the wiring comprising a copper metal and/or a copper alloy and the interlayer insulating film of a semiconductor. The material for the barrier layer is preferably a metal material having low resistance, and TiN, TiW, Ta, TaN, W and WN are particularly preferred. Among these, Ta and TaN are more preferred.

### [Insulating Material of Semiconductor Integrated Circuit]

The semiconductor integrated circuit which is a target of polishing preferably comprises an insulating material having a dielectric constant of 3 or less (low dielectric insulating film) .

The low dielectric insulating film which is one of the targets of polishing in the present invention is described below. Conventionally, SiO₂ (dielectric constant: about 4.1) has been used as the interlayer insulating film material of a semiconductor device.

The low dielectric insulating film for use in the present invention may be an organic system or an inorganic system but is preferably an organic-inorganic hybrid system such as SiOC and MSQ, or an organic polymer system such as polyimide and Teflon (registered trademark). Such a material may have fine pores.

The film formation method may be either plasma CVD or spin coating. The dielectric constant is preferably lower but in particular, the dielectric constant is preferably from 1.8 to 2.5. Specific examples of the material include "Black Diamond" (trademark, produced by Applied Materials, Inc.) of the SiOC-plasma CVD system, and "SiLK" (trademark, produced by The Dow Chemical company) of the organic polymer system.

### [Polishing Method]

There are a case where the metal polishing solution is a concentrated solution and diluted on use by adding water to prepare a working solution, a case where the components are mixed in the form of an aqueous solution described later and water is added, if desired, to prepare a working solution, and a case where the polishing solution is prepared as a working solution. The polishing method using the metal polishing solution of the present invention is applicable to any one of these cases, and this polishing method comprises supplying the polishing solution to a polishing pad on a polishing platen to come into contact with the surface to be polished, and creating a relative motion between the surface to be polished and the polishing pad, thereby effecting the polishing.

As for the polishing apparatus, a general polishing apparatus having a polishing platen (equipped with a motor or the like capable of varying the rotation number) on which a holder for holding a semiconductor or the like having the surface to be polished and a polishing pad are attached, can be used. The polishing pad is not particularly limited and, for example, a general non-woven fabric, foamed polyurethane or porous fluororesin may be used. The polishing conditions are not limited but the rotation speed of the polishing platen is preferably as low as 200 rpm or less so as to prevent a substrate from flying out. The pressure under which a semiconductor substrate having the surface to be polished (film to be polished) is pressed to the polishing pad, is preferably from 5 to 500 g/cm² and, in order to satisfy the polishing rate uniformity in wafer plane and the flatness of pattern, more preferably from 12 to 240 g/cm².

During the polishing, the metal polishing solution is continuously supplied to the polishing pad by a pump or the like. The supply amount is not limited, but the polishing pad surface is preferably always covered with the polishing solution. The semiconductor substrate after the completion of polishing is thoroughly washed with running water and after blowing off a water droplet adhering on the semiconductor substrate by using a spin dryer or the like, dried. In the polishing method of the present invention, the diluting aqueous solution is the same as the aqueous solution described below. The aqueous solution is water previously containing at least one of the oxidizing agent, acid, additive and surfactant and is prepared such that the total components of the components contained in the aqueous solution and the components of the metal polishing solution give the components for actual polishing using the metal polishing solution. In the case of using the meal polishing solution by diluting it with the aqueous solution, the hardly dissolvable component can be blended in the form of an aqueous solution and a more concentrated metal polishing solution can be prepared.

As for the method of diluting the concentrated metal polishing solution by adding water or the aqueous solution, there is known a method of causing a piping for supplying the concentrated metal polishing solution and a piping for supplying water or the aqueous solution to join together in the midway, thereby mixing the concentrated polishing solution with water or the aqueous solution, and supplying the mixed and diluted metal polishing solution to the polishing pad. The mixing may be performed by employing an ordinal method such as a method of passing the solutions through a narrow path while applying a pressure to collide and mix with each other, a method of arranging a packing material such as glass tube in the piping, and repeating the division, separation and merging of the liquid flow, or a method of providing an impeller blade capable of rotating by a driving power in the piping.

The supply rate of the metal polishing solution is preferably from 10 to 1,000 ml/min and, in order to satisfy the polishing rate uniformity in wafer plane and the flatness of pattern, more preferably from 170 to 800 ml/min.

The method of diluting the concentrated metal polishing solution with water, the aqueous solution or the like and then performing the polishing includes a method of independently providing a piping for supplying the metal polishing solution and a piping for supplying water or the aqueous solution, supplying each solution in a predetermined amount to the polishing pad, and performing the polishing while mixing the solutions by a relative motion between the polishing pad and the surface to be polished, and a method of charging a predetermined amount of the concentrated metal polishing solution and a predetermined amount of water or the aqueous solution into one vessel, mixing the solutions, supplying the mixed metal polishing solution to the polishing pad, and performing the polishing.

In another polishing method of the invention, the components which should be contained in the metal polishing solution are divided into at least two constituent components, each constituent component on use is diluted by adding water or the aqueous solution, the diluted constituent components are supplied to the polishing pad on a polishing platen to come in contact with the surface to be polished, and a relative motion is created between the surface to be polished and the polishing pad, thereby effecting the polishing.

For example, the oxidizing agent is formulated as one constituent component (A), the acid, additive, surfactant and water are formulated as one constituent component (B), and on use, these constituent components (A) and (B) are diluted with water or the aqueous solution and used.

Furthermore, by dividing the additive having low solubility into constituent components (A) and (B), the oxidizing agent, additive and surfactant are formulated as one constituent component (A), the acid, additive, surfactant and water are formulated as one constituent component (B), and on use, these constituent components (A) and (B) are diluted by adding water or the aqueous solution and used. In this case, three pipings for supplying the constituent component (A), the constituent component (B) and water or the aqueous solution, respectively, are necessary, and the dilution and mixing may be performed by a method of combining three pipings into one piping for supplying the polishing solution to the polishing pad, and effecting the mixing in the piping. At this time, it is also possible to combine two pipings and then combine the remaining one piping therewith.

This is, for example, a method where a constituent component containing a hardly dissolvable additive is mixed with another constituent component and after ensuring the dissolution time by taking a long mixing path, the piping for water or the aqueous solution is combined. Other examples of the mixing method include a method of guiding each of the above-described three pipings directly to the polishing pad and mixing the solutions by a relative motion between the polishing pad and the surface to be polished, and a method of mixing three constituent components in one vessel and supplying the diluted metal polishing solution therefrom to the polishing pad. In the above-described polishing method, it is also possible to set one constituent component containing the oxidizing agent to 40°C or less, while heating another constituent component to a temperature in the range from room temperature to 100°C, and after diluting on use the one constituent component by adding the another constituent or adding water or the aqueous solution, set the solution resulting from mixing to 40°C or less. When the temperature is high, the solubility becomes high and, accordingly, this method is preferred for increasing the solubility of the raw material having a low solubility of the metal polishing solution.

The raw material prepared by dissolving the another component not containing the oxidizing agent under heating at a temperature in the range from room temperature to 100°C causes precipitation in the solution along with dropping of the temperature and, therefore, in the case of using such a component of which temperature is lowered, the raw material needs to be previously heated to dissolve the precipitate. For this purpose, means for transferring a heated and dissolved constituent component solution and means for stirring the solution containing the precipitate and on the way of transferring, dissolving the precipitate by heating the piping may be employed. When the one constituent component in which the heated components contain the oxidizing agent is heated to a temperature of 40°C or more, the oxidizing agent may be decomposed. Therefore, in the case of mixing the heated constituent component with the oxidizing agent-containing one constituent component for cooling the heated constituent component, the temperature is set to 40°C or less.

Furthermore, in the present invention, as described above, the components of the metal polishing solution may be divided into halves and then supplied to the polishing surface. In this case, the components are preferably supplied by dividing these into components containing an oxide and components containing an acid. Also, the metal polishing solution may be supplied as a concentrated solution to the polishing surface separately from diluting water.

### [Pad]

The polishing pad may either a non-foamed structure pad or a foamed structure pad. In the former, a rigid synthetic resin bulk material such as plastic plate is used for the pad. The latter includes three types, that is, an independent cell foam (dry foaming type), a continuous cell foam (wet foaming type) and a two-layer composite (laminate type). In particular, a two-layer composite (laminate type) is preferred. The foaming may be either uniform or non-uniform.

Furthermore, the foam may contain an abrasive grain (e.g., ceria, silica, alumina, resin) for use in polishing. Each foam includes a soft type and a hard type, and the foam may have either hardness. In the laminate type, foams differing in the hardness are preferably used for respective layers. Preferred examples of the construction material include a nonwoven fabric, a synthetic leather, a polyamide, a polyurethane, a polyester and a polycarbonate. Also, the surface which comes into contact with the polishing surface may be subjected to a treatment such as lattice groove, hole, concentric groove and helical groove.

### [Wafer]

The target wafer subjected to CMP by the metal polishing solution of the present invention preferably has a diameter of 200 mm or more, more preferably 300 mm or more. When the diameter is 300 mm or more, the effect of the present invention is remarkably brought out.

### EXAMPLES

The present invention is described below by referring to Examples, but the present invention is not limited to these Examples.

### <Example 1>

A polishing solution shown, below was prepared, subjected to a polishing test and evaluated.

### (Preparation of Polishing Solution)

| | |
|---|---|
| Colloidal silica (average particle diameter: 30 nm) | |
| Heteroaromatic ring compound or benzotriazole (BTA) | 0.001 M |
| Hydrogen peroxide (oxidizing agent) | 15 g/L |
| Compound represented by formula (1) or (2) of glycine | 0.08 M |
| Dodecylbenzenesulfonic acid (DBS) (in an amount shown in Table 3) | |
| Pure water added to make a total amount of | 1,000 mL |
| pH adjusted to | 6.8 |

### (Polishing Test)

Substrate: silicon substrate having formed thereon a copper/silver alloy film having a thickness of 1 µm
Polishing pad: IC1400K-Groove (produced by Rodel Corp.)
Polishing apparatus: LGP-612 (produced by LapmaSter FT Co.)
Pressing pressure: 240 g/cm²
Polishing solution supply rate: 170 mL/min
Wafer diameter: 200 mm
Wafer: Cu blanket wafer or pattern wafer CMP854 produced by Sematech Inc. (200 mm)
Rotation number of polishing pad/wafer: 95/95 rpm

### (Evaluation Method)

### [Polishing Rate]

The film thickness of a metal film before and after CMP was measured at 49 sites on the wafer surface by the conversion from an electric resistance value, and the average polishing rate was determined.

### [Dishing]

The pattern wafer CMP854 produced by Sematech Inc. was polished until Ta was exposed, and further overpolished for the 30% portion, and the dishing of the obtained sample was determined as the difference of level in the line (100 µm)-and-space (100 µm) part by a stylus-type step meter, Dektak V320Si (manufactured by Veeco).

The determination of oxidation reaction rate at the initial stage of oxidation and in the stationary state according to the measurement of a corrosion current was performed by the following method. Model 263A manufactured by Princeton Applied Research (PAR) Corp. was used as the electrochemical measuring device, a silver-silver chloride electrode was used as the reference electrode, a copper plate having a purity of 99.99% or more was used as the working electrode, and a platinum electrode was used as the counter electrode. A polishing solution having added thereto an oxidizing agent and a polishing solution excluding an oxidizing solution were prepared, the open potential (corrosion potential) in the case of using each solution was determined by the above-described measuring device, and the potential difference thereof was defined as the oxidation potential of the oxidizing agent. Using a polishing solution having not added thereto an oxidizing agent, a voltage for the oxidation potential portion was applied to the open circuit state and the time change of the corrosion current density (A/cm²) was traced for a sampling time of 100 msec. The corrosion current density (A/cm²) was converted into an oxidation reaction rate (nm/min) by using the Faraday constant, copper molecular weight and metallic copper density.

The adsorptivity of the heteroaromatic ring compound to metallic copper and copper oxide was measured by the following method. The surface areas of a metallic copper particle and a copper oxide particle each having a particle diameter of about several mm were measured by the BET method, and a metallic copper particle and a copper oxide particle each in an amount of giving a surface area of 0.005 m² were subjected to surface washing with 0.1 N sulfuric acid. Thereafter, each particle was dispersed in 100 ml of water. To this liquid dispersion, 1 ml of an aqueous 7.5×10⁻⁶ M heteroaromatic ring compound solution was added and stirred at 40°C for 30 minutes. Subsequently, the heteroaromatic ring compound concentration of the supernatant was quantitatively determined by ICP, and the amount of adsorption was calculated back. The adsorption selectivity to copper oxide/metallic copper of the heteroaromatic ring compound was expressed by a ratio between these amounts of adsorption.

Heteroaromatic Ring Compounds H-1 to H-5 in Table 3 are the following compounds, and the LogP values of these compounds are shown together with Compound I-1 and BTA.

| | | LogP value |
|---|---|---|
| H-1: | 2-Aminopyrrole | -0.48 |
| H-2: | 2,6-Diaminopyridine | 0.01 |
| H-3: | Triazole | -0.19 |
| H-4: | 5-Carboxytriazole | -0.15 |
| H-5: | Pyrrole | 0.75 |
| I-1: | Compound shown above | -1.10 |
| BTA: | Benzotriazole | 1.41 |

**Table 3**

| | Composition | | | | Physical Properties | | | | Evaluation | |
|---|---|---|---|---|---|---|---|---|---|---|
| | Compound of Formula (1) or (2) Ring or Glycine (0.08 M) | Hetero-aromatic Compound (0.001M) | Concentration of Abrasive Grain (mass%) | DBS (mass%) | E1/E2 | Time Taken to Reach (EI+E2)/2 | E2 | Adsorption Selectivity to Copper Oxide/ Metallic Copper | Polishing Rate (nm/min) | Dishing (nm) |
| Example 1 | glycine | 1-1 | 1.2 | 0 | 5.2 | 3.5 | 0.12 | 2.7 | 420 | 62 |
| 2 | glycine | I-2 | 1.2 | 0 | 7.3 | 5.6 | 0.20 | 5.3 | 471 | 55 |
| 3 | glycine | I-4 | 1.2 | 0 | 4.8 | 2.9 | 0.53 | 3.4 | 626 | 88 |
| 4 | glycine | I-5 | 1.2 | 0 | 5.1 | 2.2 | 0.42 | 4.5 | 417 | 90 |
| 5 | glycine | I-26 | 1.2 | 0 | 3.7 | 10.6 | 0.11 | 8.0 | 511 | 39 |
| 6 | glycine | I-48 | 1.2 | 0 | 6.5 | 8.2 | 0.10 | 6.8 | 387 | 43 |
| 7 | glycine | II-5 | 1.2 | 0 | 5.0 | 11.2 | 0.76 | 5.9 | 350 | 72 |
| 8 | glycine | II-9 | 1.2 | 0 | 4.1 | 15.3 | 0.43 | 3.1 | 493 | 89 |
| 9 | glycine | H-1 | 1.2 | 0 | 3.5 | 3.5 | 1.32 | 3.0 | 377 | 65 |
| 10 | glycine | H-2 | 1.2 | 0 | 2.1 | 1.7 | 2.33 | 1.9 | 342 | 118 |
| 11 | glycine | H-3 | 1.2 | 0 | 2.8 | 2.5 | 1.21 | 2.1 | 441 | 96 |
| 12 | glycine | H-4 | 1.2 | 0 | 2.8 | 3.0 | 0.75 | 2.7 | 499 | 72 |
| 13 | glycine | I-1 | 1.2 | 0 | 7.9 | 13.4 | 0.05 | 2.9 | 410 | 41 |
| 14 | A-5 | I-1 | 1.2 | 0 | 7.9 | 13.4 | 0.05 | 2.9 | 391 | 37 |
| 15 | A-5 | I-1 | 0.6 | 0 | 7.9 | 13.4 | 0.05 | 2.9 | 311 | 34 |
| 16 | A-5 | I-1 | 0 | 0 | 6.9 | 26.8 | 0.02 | 3.4 | 512 | 32 |
| Comparative Example 1 | A-5 | BTA | 0.6 | 0.4 | 1.3 | 0.6 | 0.62 | 0.81 | 395 | 180 |
| 2 | A-5 | BTA | 1.2 | 0.4 | 1.0 | - | 1.05 | 0.53 | 478 | 246 |
| 3 | glycine | H-5 | 1.2 | 0.4 | 1.2 | 0.2 | 0.85 | 0.91 | 439 | 192 |

It is seen that in the case of the metal polishing solution of the present invention, the dishing is remarkably small and the polishing rate is high.

This application is based on Japanese Patent application JP 2005-77102, filed March 17, 2005, the entire content of which is hereby incorporated by reference, the same as if set forth at length.

## Claims

1. A metal polishing solution comprising an oxidizing agent, wherein assuming that an oxidation reaction rate immediately after an oxidation of a metal to be polished starts at its surface is E1 and an oxidation reaction rate when an oxidation reaction reaches a stationary state is E2, E1/E2 is 1.5 or more and a time required for reaching an oxidation reaction rate of (E1+E2)/2 is from 1 to 50 seconds.

2. The metal polishing solution as claimed in claim 1, wherein the oxidation reaction rate E2 is 1.0 nm/min or less.

3. The metal polishing solution as claimed in claim 1, which comprises a heteroaromatic ring compound having higher adsorptivity to copper oxide than an adsorptivity to metallic copper.

4. The metal polishing solution as claimed in claim 3, wherein said heteroaromatic ring compound is at least one member selected from the compounds represented by the following formulae (I) and (II): 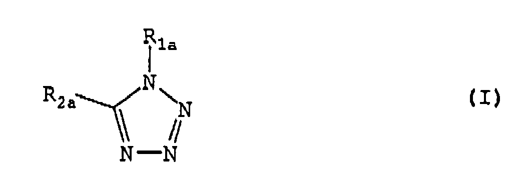 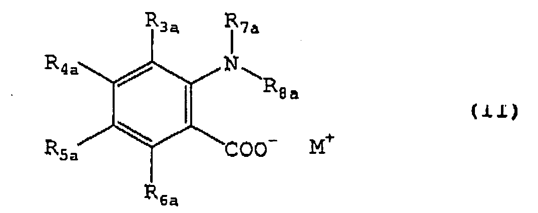 wherein in formula (I), R₁ₐ and R₂ₐ each independently represents a hydrogen atom or a substituent, and R₁ₐ and R₂ₐ may combine with each other to form a ring, provided that when R₁ₐ and R₂ₐ both are a hydrogen atom, the compound represented by formula (I) may be a tautomer thereof, and
in formula (II), R₃ₐ to R₈ₐ each independently represents a hydrogen atom or a substituent, adjacent two members out of R₃ₐ to R₆ₐ may combine with each other to form a ring, and M⁺ represents a cation.

5. The metal polishing solution as claimed in claim 1, which comprises an abrasive grain in a proportion of 2 mass% or less.

6. The metal polishing solution as claimed in claim 5, wherein the abrasive grain has an average diameter of 50 nm or less, and a coefficient of variation of the abrasive grain diameter is 20% or less.

7. The metal polishing solution as claimed in claim 1, which further comprises a compound represented by the following formula (1) or (2): 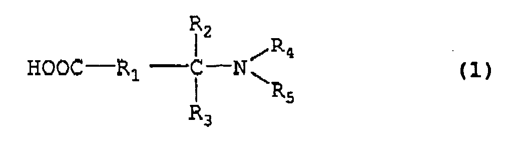 wherein R₁ represents a single bond, an alkylene group or a phenylene group,
R₂ and R₃ each independently represents a hydrogen atom, a halogen atom, a carboxyl group, an alkyl group, a cycloalkyl group, an alkenyl group, an alkynyl group or an aryl group, and
R₄ and R₅ each independently represents a hydrogen atom, a halogen atom, a carboxyl group, an alkyl group or an acyl group,
provided that when R₁ is a single bond, at least one of R₄ and R₅ is not a hydrogen atom; 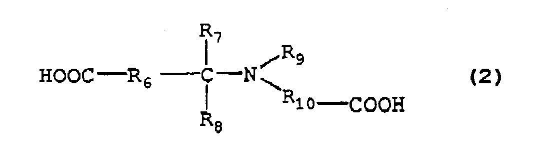 wherein R₆ represents a single bond, an alkylene group or a phenylene group,
R₇ and R₈ each independently represents a hydrogen atom, a halogen atom, a carboxyl group, an alkyl group, a cycloalkyl group, an alkenyl group, an alkynyl group or an aryl group,
R₉ represents a hydrogen atom, a halogen atom, a carboxyl group or an alkyl group, and
R₁₀ represents an alkylene group,
provided that when R₁₀ is -CH₂-, at least either R₆ is not a single bond or R₉ is not a hydrogen atom.

8. The metal polishing solution as claimed in claim 1, which further comprises a surfactant.

9. The metal polishing solution as claimed in claim 1, wherein a target of polishing is a semiconductor integrated circuit including an insulating material with a dielectric constant of 3 or less.

10. The metal polishing solution as claimed in claim 1, wherein a target of polishing is a semiconductor integrated circuit including a copper-containing wiring.

11. A chemical-mechanical polishing method comprising bringing the metal polishing solution claimed in claim 1 into contact with a surface to be polished, and creating a relative motion between the surface to be polished and at least one of the polishing solution and a polishing pad.
